# EUROPÄISCHE PATENTSCHRIFT

(11) **EP 2 856 652 B1**
(45) Veröffentlichungstag und Bekanntmachung des Hinweises auf die Patenterteilung: **10.07.2019**
(21) Anmeldenummer: 13722285.7
(22) Anmeldetag: 06.05.2013
(51) Int. Cl.: H03M 5/12

(54) **DEKODIERUNG EINES MANCHESTER CODES OHNE PLL FÜR KURZE DATENSEQUENZEN**
DECODING OF A MANCHESTER CODE WITHOUT PLL FOR SHORT DATA SEQUENCES
DÉCODAGE D'UN CODE DE MANCHESTER SANS PLL POUR SÉQUENCES DE DONNÉES COURTES

(30) Priorität: 29.05.2012 DE 102012010375
(43) Veröffentlichungstag der Anmeldung: 08.04.2015
(60) Teilanmeldung: 17000217.4
(73) Patentinhaber: SEW-EURODRIVE GmbH & Co. KG, 76646 Bruchsal (DE)
(72) Erfinder: SIMON, Olaf, 76646 Bruchsal (DE); QUADT, Steffen, 76139 Karlsruhe (DE); MÜLLER, Michael, 76137 Karlsruhe (DE); HOFFMANN, Julian, 67729 Sippersfeld (DE)
(86) Internationale Anmeldenummer: PCT/EP2013/001327
(87) Internationale Veröffentlichungsnummer: WO 2013/178318

(56) Entgegenhaltungen:
- EP-A2- 0 488 506
- EP-A2- 1 528 738
- US-A1- 2010 208 849

## Beschreibung

Die Erfindung betrifft ein Dekodierungsverfahren und eine Dekodiereinrichtung.

Die Manchester-Kodierung dient der Übertragung von Signalen von einem Sender zu einem Empfänger. In der Regel liegt der Sendedatenstrom in Form eines Daten-Signals und eines Clock-Signals vor. Um die Übertragung von zwei Signalen vom Sender zum Empfänger zu vermeiden, wird aus dem Clock-Signal und dem Datensignal ein Manchester-kodiertes Signal generiert. Damit ist es möglich, den Datenstrom über eine gemeinsame Signalleitung an den Empfänger zu übertragen. Da der Empfänger zur weiteren Verarbeitung jedoch ebenfalls wieder ein Clock-Signal und ein Daten-Signal benötigt, muß das Manchester-kodierte Signal wieder dekodiert werden. Diese Dekodierung erfordert die Rückgewinnung des Clock-Signals aus dem gesendeten Signal.

Bei den im Stand der Technik bekannten Dekodie-rungsverfahren synchronisiert sich der Empfänger im einfachsten Fall auf das erste empfangene Startbit auf und wertet alle folgenden Bits jeweils zur halben a priori bekannten Bitzeit aus. Damit auch noch das letzte Bit korrekt ausgelesen werden kann, darf die Zeitbasis des Empfänger nach dem letzten übertragenen Bit maximal um die halbe Bitzeit abgewichen sein. Das Manchester-kodierte Signal muß also mit einer Frequenz abgetastet werden, die für typische Anwendungsfälle nur um 0,2 % von der Sendefrequenz abweichen darf. Diese Anforderung ist nur mit großem Aufwand zu erfüllen und in jedem Fall relativ störanfällig.

Bekannte Dekodierungsverfahren setzen daher auf Phasenregelschleifen (Phase-Locked-Loop, PLL), die aufgrund der auftretenden Signalflanken im Eingangssignal kontinuierlich die Abtastfrequenz des Empfängers derart nachführen, dass diese möglichst synchron zur Senderfrequenz gehalten wird. Auf diese Weise wird das Clock-Signal des Senders rekonstruiert. Nachteile von Verfahren, die ein synchronisiertes Clock-Signal für die Abtastung des Eingangssignals erzeugen, liegen jedoch darin, dass Störungen auf dem Eingangssignal mögli-cherweise in den Abtastzeitpunkt fallen und somit Fehler in der Dekodierung verursachen. Ein Beispiel für die einmalige Abtastung des Eingangssignals innerhalb einer halben Bitzeit ist in US 4 881 059 A zu finden.

Ein weiterer Nachteil der PLLs besteht darin, dass es sich um eine rückgeführte beziehungsweise geregelte Struktur handelt, die bis zur gewünschten Funktion eine Einschwingzeit durchlaufen muß und deren Auslegung der Regelparameter auf mögliche Instabilitäten hin optimiert sein muß. Insbesondere bei kurzen Telegrammen, die jeweils mit einer zeitlichen Unterbrechung gesendet werden, führt dies dazu, dass jeweils eine neue Einschwingphase hervorgerufen wird. Dies kann dazu führen, dass der Beginn eines jeden Telegramms möglicherweise nicht korrekt dekodiert werden kann.

In US 7 133 482 B2 ist ein Verfahren beschrieben, mit dem die beschriebenen Nachteile vermieden werden soll. Dabei wird eine zweistufige Signalauswertung vorgenommen. In einer ersten Stufe wird das Empfangssignal gefiltert, so dass Störungen das nachgeschaltete Auswerteverfahren nicht negativ beeinflussen können. Die Auswertung erfolgt nachgelagert dadurch, dass das gefilterte Eingangssignal zu festgelegten Zeitpunkten nach der letzten erkannten Flanke ausgewertet wird, wodurch ohne PLL eine kontinuierliche Anpassung an den Takt des Senders erfolgt. Als Eingangsfilter wird ein bereichsbegrenzter Integrator verwendet.

In US 5 696 800 wird ein Verfahren beschrieben, bei dem die Fehlertoleranz durch die Erzeugung von zwei Clock-Signalen erreicht wird, die mit Filtern verschiedener Bandbreiten erzeugt werden. Hierdurch entstehen jedoch aufwendige Strukturen.

In US 6 370 212 B1 wird für die Auswertung des Manchester-kodierten Signals die Verwendung eines gleitenden Mittelwertfilters eingeführt. Diese Implementierung generiert das dekodierte Clock-Signal jedoch nach wie vor aus einer dem gleitenden Mittelwertfilter nachgeschalteten Phasenregelschleife. Hierdurch kann ein eingehendes Signal erst ab dem Zeitpunkt ausgewertet werden, ab dem die Phasenregelschleife auch synchronisiert ist. Damit ist die komplette Dekodierung kurzer Signalfolgen nicht möglich. Weiterhin werden Transitionspunkte als Eingangssignal für die Phasenregelschleife generiert. Da dieses Signal aus dem ersten Steigungswechsel abgeleitet wird, können sich bei gestörten Eingangssignalen deutliche zeitliche Abweichungen ergeben, die die Entscheidung erschweren, ob die Phasenregelschleife eingerastet ist und damit die dekodierten Signal gültig sind. Es wird daher nur eine begrenzte Störunempfindlichkeit erreicht.

Aus US 2010/0208849 A1 sind ein Empfangsschaltkreis, dessen Verwendung und ein Verfahren zum Empfang eines kodierten und modulierten Radiosignals bekannt, wobei über einen Umschalter alternativ zwei Signale einer Phasenregelschleife zur Regenerierung eines Clocksignals zugeführt werden. Der Empfangsschaltkreis dient zur Dekodierung von Manchester kodierten Daten. In dem Empfangsschaltkreis werden ein Datenmittelwert und Clock-Mittelwert gebildet. Ein Komparator mit einem Schwellwert von Null stellt die dekodierten Daten bereit.

Aus EP 1 528 738 A2 sind ein Amplitudenumtastungs-Demodulationsgerät und ein drahtloses Gerät zu dessen Verwendung bekannt, wobei eine Clock-Extraktionseinheit detektiert, dass ein Nulldurchgangs-Zeitinterval gleich einer Bit-Zeit ist, und eine Clock-Wiederherstellungseinheit ein richtiges Daten-Clock-Signal durch Synchronisation mit einem vorhandenen Daten-Clock-Signal wiederherstellt.

In der Druckschrift EP 0 488 506 A2 ist beschrieben, dass bei dem Standard IEEE 802.3 10BASE-T ein Datenpaket einen End-of-Transmission-Begrenzer aufweisen Das ETD Signal bleibt hoch für eine über die Bit-Dauer erhöhte Zeitspanne.

Der Erfindung liegt die Aufgabe zugrunde, ein Dekodierungsverfahren weiterzubilden, welches die Verarbeitung kurzer Telegramme von Manchester-kodierten Signalen erlaubt.

Erfindungsgemäß wird die Aufgabe bei dem Dekodierungsverfahren mit den in Anspruch 1 angegebenen Merkmalen und bei der Dekodiereinrichtung mit den in Anspruch 13 angegebenen Merkmalen gelöst.

Wichtige Merkmale der Erfindung eines Dekodierungsverfahrens für ein Manchester-kodiertes Signal sind, dass für das Manchester-kodierte Signal ein gleitender Daten-Mittelwert mit einer Daten-Mittelwertzeit gebildet wird und dass aus dem gleitenden Daten-Mittelwert mit einem Daten-Komparator ein dekodiertes Daten-Signal gebildet und bereitgestellt wird. Von Vorteil ist dabei, dass nur Bauelemente erforderlich sind, die vergleichsweise kurze Einschwingzeiten aufweisen. Somit sind kurze Daten-Telegramme in Manchester-Kodierung verarbeitbar.

Erfindungsgemäß ist vorgesehen, dass für das Manchester-kodierte Signal ein gleitender EOT-Mittelwert mit einer EOT-Mittelwertzeit gebildet wird, dass die EOT-Mittelwertzeit länger als die Daten-Mittelwertzeit ist und dass aus dem gleitenden EOT-Mittelwert mit einem EOT-Komparator ein EOT-Signal gebildet und bereitgestellt wird. Hierbei bezeichnet die Abkürzung EOT das Übertragungsende, englisch end of transmission. Bevorzugt ist vorgesehen, dass die EOT-Mittelwertzeit auch länger als die Clock-Mittelwertszeit ist. Von Vorteil ist dabei, dass das Übertragungsende automatisiert erkennbar ist. Dies kann beispielsweise für eine Rücksetzung der unterschiedlichen Komparatoren, insbesondere der Schwellwerte, und/oder Mittelwertbilder verwendet werden.

Bei einer vorteilhaften Ausgestaltung kann vorgesehen sein, dass zur Bildung des Clock-Signals ein Ausgangssignal des Clock-Komparators mit einem Ausgangssignal des Daten-Komparators logisch verknüpft wird. Bevorzugt wird das Ausgangssignal des Clock-Komparators mit dem Ausgangssignal des Daten-Komparators, insbesondere dem Daten-Signal, verknüpft. Besonders günstig ist es, wenn die genannten Ausgangssignale durch XOR-Verknüpfung logisch verknüpft werden. Von Vorteil ist dabei, dass ein einfaches Verfahren angegeben ist, mit welchem das Clock-Signal rekonstruierbar ist. Phasenregelschleifen sind verzichtbar, so dass kurze Einschwing- und Ansprechzeiten erreichbar sind. Diese Ausgestaltung ist mit Vorteil bei einer Ausgestaltung einsetzbar, bei welcher in der beschriebenen Art ein Daten-Signal und ein Clock-Signal gebildet werden. Bei einer vorteilhaften Ausgestaltung kann vorgesehen sein, dass die Clock-Mittelwertzeit kürzer als die Daten-Mittelwertzeit ist. Somit ist das geringfügig gegenüber dem Daten-Signal höherfrequente Clock-Signal leicht abtrennbar.

Bei einer vorteilhaften Ausgestaltung kann vorgesehen sein, dass zur Bildung des gleitenden Daten-Mittelwerts, des gleitenden Clock-Mittelwerts und/oder des gleitenden EOT-Mittelwerts ein aus dem Manchester-kodierten Signal abgeleitetes Signal über die Daten-, Clockbeziehungsweise EOT-Mittelwertzeit integriert wird. Es kann somit vorgesehen sein, dass einzelne oder alle der aufgeführten Mittelwerte durch Integration gewonnen werden. Die Integration stellt ein einfaches Mittel dar, um die Mittelwerte zu berechnen.

Bei einer vorteilhaften Ausgestaltung kann vorgesehen sein, dass zur Bildung des gleitenden Daten-, Clock- und/oder EOT-Mittelwerts fortschreitend ein Differenzsignal von Differenzen zwischen jedem Symbol des Manchester-kodierten Signals und einem zu diesem Symbol um eine vorgegebene Zeitdauer zeitversetzten Symbol der Manchester-kodierten Signalfolge als das aus dem Manchester-kodierten Signal abgeleitete Signal gebildet wird. Von Vorteil ist dabei, dass auf einfache Weise ein abgeleitetes Signal bereitstellbar ist und bereitgestellt wird, aus welchem durch Integration oder auf andere Weise ein gleitender Mittelwert bildbar ist.

Erfindungsgemäß ist vorgesehen, dass der Daten-Komparator den gleitenden Daten-Mittelwert mit wenigstens einem Daten-Schwellwert vergleicht und das dekodierte Daten-Signal in Abhängigkeit von einem Überschreiten oder Unterschreiten des wenigstens einen Daten-Schwellwerts ausgibt. Von Vorteil ist dabei, dass mit dem Daten-Komparator auf einfache Weise aus dem feinstufigen oder analogen gleitenden Daten-Mittelwert ein binäres Signal gewinnbar ist.

Erfindungsgemäß ist vorgesehen, dass der wenigstens eine Daten-Schwellwert einen unteren Daten-Schwellwert und einen oberen Daten-Schwellwert umfasst und dass der Daten-Komparator das dekodierte Signal in Abhängigkeit von einem Überschreiten des oberen Daten-Schwellwerts und einem Unterschreiten des unteren Daten-Schwellwerts ausgibt. Von Vorteil ist dabei, dass auf diese Weise ein Hystereseverhalten des Daten-Komparators abbildbar ist. Dies ist besonders günstig für die Erzeugung des binären Signals, da im Übergangsbereich der Schwellwerte ein zu häufiges Umschalten vermieden werden kann.

Bei einer vorteilhaften Ausgestaltung kann vorgesehen sein, dass der untere Daten-Schwellwert gleich dem oberen Clock-Schwellwert oder größer als der obere Clock-Schwellwert ist. Hierbei ergibt sich eine besonders günstige Trennung des Daten-Signals von dem Clock-Signal.

Bei einer vorteilhaften Ausgestaltung kann vorgesehen sein, das ein arithmetischer Mittelwert des unteren Daten-Schwellwerts und des oberen Daten-Schwellwerts zwischen Null und Eins, insbesondere zwischen 0,3 und 0,7 oder bei 1/2 liegt. Es hat sich herausgestellt, dass die symmetrische Anordnung des arithmetischen Mittelwerts und/oder des unteren und des oberen Schwellwerts in Bezug auf die Grenzen 0 und 1 besonders günstig für die Extraktion des Datensignals ist.

Bei einer vorteilhaften Ausgestaltung kann vorgesehen sein, dass als Daten-Mittelwertzeit eine Zeitdauer, die größer als eine halbe Bitzeit eines Clock-Signals des Manchester-kodierten Signals ist, eingerichtet wird. Es kann auch vorgesehen sein, dass als Daten-Mittelwertzeit eine Zeitdauer, die kleiner als das 1,5fache der Bitzeit eines Clock-Signals des Manchester-kodierten Signals ist. Werden diese Bereichsgrenzen kombiniert, so ergibt sich als vorteilhafte Ausgestaltung, dass als Daten-Mittelwertzeit eine Zeitdauer, die zwischen einer halben Bitzeit und dem 1,5fachen der Bitzeit des Clock-Signals des Manchester-kodierten Signals liegt, gewählt ist. Es hat sich herausgestellt, dass für diese Werte besonders robuste Dekodierungen des Daten-Signals erreichbar sind. Besonders günstig ist es, wenn als Daten-Mittelwertzeit eine Zeitdauer, die zwischen dem 0,8fachen und dem 1,2fachen der Bitzeit des Clock-Signals liegt, insbesondere die gleich der Bitzeit des Clock-Signals ist, eingerichtet wird.

Bei einer vorteilhaften Ausgestaltung kann vorgesehen sein, dass als Clock-Mittelwertzeit eine Zeitdauer, die kleiner als eine Bitzeit, eines Clock-Signals des Manchester-kodierten Signals ist, eingerichtet wird. Von Vorteil ist dabei, dass auf diese Weise ein Filter für gegenüber dem Daten-Signal vergleichsweise höhere Frequenzen bildbar ist, mit welche das Clock-Signal enthalten. Besonders günstig ist es, wenn als Clock-Mittelwertzeit eine Zeitdauer, die zwischen dem 0,3fachen und dem 0,7fachen der Bitzeit des Clock-Signals liegt, insbesondere die gleich der halben Bitzeit eines Clock-Signals des Manchester-kodierten Signals ist, eingerichtet wird.

Bei einer vorteilhaften Ausgestaltung kann vorgesehen sein, dass als EOT-Mittelwertzeit eine Zeitdauer, die größer als eine Bitzeit eines Clock-Signals des Manchester-kodierten Signals ist, eingerichtet wird. Von Vorteil ist dabei, dass auf diese Weise ein Filter für gegenüber dem Daten-Signal vergleichsweise niedere Frequenzen bildbar ist, mit welchem das Übertragungsende einfach erkennbar ist. Besonders günstig ist es, wenn als EOT-Mittelwertzeit eine Zeitdauer, die zwischen dem 1,3fachen und dem 1,7fachen der Bitzeit des Clock-Signals liegt, insbesondere die gleich der 1,5fachen Bitzeit eines Clock-Signals des Manchester-kodierten Signals ist, eingerichtet wird.

Bei einer vorteilhaften Ausgestaltung kann vorgesehen sein, dass der Clock-Komparator den gleitenden Clock-Mittelwert mit wenigstens einem Clock-Schwellwert vergleicht und ein Ausgabesignal in Abhängigkeit von einem Überschreiten oder Unterschreiten des wenigstens einen Clock-Schwellwerts ausgibt. Von Vorteil ist dabei, dass ein binäres Signal aus dem feinstufigen oder analogen gleitenden Clock-Mittelwert bildbar und bereitstellbar ist.

Bei einer vorteilhaften Ausgestaltung kann vorgesehen sein, dass der wenigstens eine Clock-Schwellwert einen unteren Clock-Schwellwert und einen oberen Clock-Schwellwert umfasst und dass der Clock-Komparator ein Ausgabesignal in Abhängigkeit von einem Überschreiten des oberen Clock-Schwellwerts und/oder einem Unterschreiten des unteren Clock-Schwellwerts ausgibt. Von Vorteil ist dabei, dass ein Hystereseverhalten an dem Clock-Komparator realisierbar ist. Hierdurch ist eine besonders störunempfindliche Erzeugung eines Clock-Signals erreichbar.

Bei einer vorteilhaften Ausgestaltung kann vorteilhaft sein, dass ein arithmetischer Mittelwert des unteren Clock-Schwellwerts und des oberen Clock-Schwellwerts zwischen Null und Eins liegt oder gewählt wird. Besonders günstig ist es, wenn der arithmetische Mittelwert des unteren Clock-Schwellwerts und des oberen Clock-Schwellwerts unterhalb des arithmetischen Mittelwerts von unterem Daten-Schwellwert und oberem Daten-Schwellwert liegt. Besonders bevorzugt ist es, wenn der arithmetische Mittelwert des unteren Clock-Schwellwerts und des oberen Clock-Schwellwerts zwischen 0,2 und 0,3 oder bei 1/4 liegt. Es hat sich herausgestellt, dass für die angegebenen Zahlenwerte besonders robuste Dekodierungsverfahren bildbar sind.

Die hier und in der gesamten Beschreibung angegebenen Signalstärken, insbesondere für Schwellwerte und Mittelwerte, sind bevorzugt jeweils auf die Flankenhöhe des Manchester-kodierten Signals bezogen.

Bei einer vorteilhaften Ausgestaltung kann vorgesehen sein, dass der gleitende Daten-, Clock- und/oder EOT-Mittelwert gleichzeitig und/oder zeitlich parallel zueinander gebildet wird/werden. Von Vorteil ist dabei, dass ein besonders schnelles Dekodierungsverfahren bereitstellbar ist, mit welchem die eingehenden Daten in Echtzeit dekodierbar sind.

Bei einer vorteilhaften Ausgestaltung kann vorgesehen sein, dass der gleitende Daten-, Clock- und/oder EOT-Mittelwert mit einer Sampling-Rate gebildet wird/werden, die jeweils kleiner als die oder eine Bitzeit des oder eines Clock-Signals des Manchester-kodierten Signals ist. Von Vorteil ist dabei, dass eine feinstufige Bildung des jeweiligen Mittelwerts möglich ist. Bevorzugt ist vorgesehen, dass die Sampling-Rate kleiner als 1/10 oder sogar als 1/100 der Bitzeit des Clock-Signals ist. Bevorzugt beträgt die Sampling-Rate 1/256 der Bitzeit.

Bei einer vorteilhaften Ausgestaltung kann vorgesehen sein, dass der gleitende Daten-, Clock- und/oder EOT-Mittelwert zeitgleich zu einer Bereitstellung weiterer Symbole des Manchester-kodierten Signals gebildet wird/werden. Von Vorteil ist dabei, dass die dekodierte Information bereits bereitstellbar und weiterverarbeitbar ist, wenn das Telegramm noch nicht vollständig empfangen ist.

Die beschriebenen Verfahrensschritte zur Bildung des Daten-Signals, des Clock-Signals und des EOT-Signals sind bei weiteren Ausführungsbeispielen miteinander kombiniert. Beispielsweise ist bei einer vorteilhaften Ausgestaltung vorgesehen, dass in der beschriebenen Art und Weise ein Daten-Signal und ein Clock-Signal gebildet werden. Bei weiteren Ausführungsbeispielen ist vorgesehen, dass in der beschriebenen Art und Weise ein Daten-Signal und ein EOT-Signal gebildet werden. Bei einer weiteren Ausgestaltung ist vorgesehen, dass in der beschriebenen Art und Weise ein Clock-Signal und ein EOT-Signal gebildet werden. Schließlich ist bei einer weiteren Ausgestaltung vorgesehen, dass ein Daten-, ein Clock- und ein EOT-Signal gebildet werden.

Wichtige Merkmale der Erfindung einer Dekodiereinrichtung mit einem Signaleingang für ein Manchester-kodierbares Signal und einem Daten-Signalausgang für ein aus dem Manchester-kodierten Signal dekodiertes Daten-Signal sind, dass ein Daten-Signalflussweg vom Signaleingang zu einem gleitenden Daten-Mittelwertbilder, von diesem zu einem Daten-Komparator und von diesem zu dem Daten-Signalausgang eingerichtet ist. Hierbei bezeichnet ein Signalflussweg den Weg, den die Signale bei der Verarbeitung, beispielsweise nach dem erfindungsgemäßen Dekodierungs-verfahren, durch die Dekodiereinrichtung nehmen. Von Vorteil ist dabei, dass eine Dekodiereinrichtung bereitgestellt ist, mit welcher ein erfindungsgemäßes Dekodierverfahren ausführbar ist, bei welchem ein dekodiertes Daten-Signal bereitgestellt wird. Hierbei kann der gleitende Daten-Mittelwertbilder zur Bildung eines gleitenden Daten-Mittelwerts eingerichtet sein. Unter einem Komparator wird allgemein eine Vergleichsschaltung verstanden, welche ein Eingangssignal mit einem vorgegebenen Signal, beispielsweise einem Schwellwert, oder einem weiteren Eingangssignal, beispielsweise einem veränderlichen Schwellwert, vergleicht und das Ergebnis dieses Vergleichs als Ausgangssignal ausgibt.

Alternativ oder zusätzlich kann bei einer Ausgestaltung von möglicherweise eigenständiger Bedeutung vorgesehen sein, dass die Dekodiereinrichtung mit einem Signaleingang für ein Manchester-kodierbares Signal und einem Daten-Signalausgang für ein aus dem Manchester-kodierten Signal dekodiertes Daten-Signal ausgerüstet ist und dass ein Clock-Signalflussweg vom Signaleingang zu einem gleitenden Clock-Mittelwertbilder, von diesem zu einem Clock-Komparator und von diesem zu einem Clock-Signalausgang eingerichtet ist. Von Vorteil ist dabei, dass bei der Bildung des Clock-Signals Phasenregelschleifen verzichtbar sind. Es sind so kurze Einschwingzeiten erreichbar.

Erfindungsgemäß ist vorgesehen, dass die Dekodiereinrichtung mit einem Signaleingang für ein Manchester-kodierbares Signal und einem Daten-Signalausgang für ein aus dem Manchester-kodierten Signal dekodiertes Daten-Signal ausgerüstet ist und dass ein EOT-Signalflussweg vom Signaleingang zu einem gleitenden EOT-Mittelwertbilder, von diesem zu einem EOT-Komparator und von diesem zu dem EOT-Signalausgang eingerichtet ist. Von Vorteil ist dabei, dass das Übertragungsende (EOT) mit einfachen Mitteln auch für kurze Telegramme und Signalfolgen erkennbar ist. Besonders günstig ist es, wenn der EOT-Komparator in Steuerverbindung mit dem gleitenden Clock-Mittwelwertbilder und/oder dem gleitenden Daten-Mittelwertbilder, um den gleitenden Clock-Mittwelwertbilder und/oder den gleitenden Daten-Mittelwertbilder bei detektiertem Übertragungsende zurückzusetzen.

Bei einer Ausgestaltung der Erfindung kann vorgesehen sein, dass eine untere Grenze eines Integrators im gleitenden Daten-Mittelwertbilder begrenzt ist, insbesondere auf 0,5 begrenzt ist, solange kein Eingangssignal erkannt ist, insbesondere durch den EOT-Komparator. Von Vorteil ist dabei, dass eine führende logische Null im Manchester-kodierten Signal zur Markierung des Übertragungsbeginns verzichtbar ist.

Besonders günstig ist es, wenn die erfindungsgemäße Dekodiereinrichtung wenigstens zwei oder drei Signalflusswege aus der Gruppe von Daten-Signalflussweg, Clock-Signalflussweg und EOT-Signalflussweg aufweist. Für viele Zwecke ist es bereits ausreichend, wenn in der erfindungsgemäßen Dekodiereinrichtung ein Daten-Signalflussweg und ein Clock-Signalflussweg in der beschriebenen Weise ausgebildet sind.

Bei einer vorteilhaften Ausgestaltung kann vorgesehen sein, dass mit dem gleitenden Daten-Mittelwertbilder ein gleitender Mittelwert des Manchester-kodierten Signals über eine Daten-Mittelwertzeit bildbar ist. Von Vorteil ist dabei, dass ein Mittelwertbilder ein praktikables Werkzeug darstellt, mit welchem ein gleitender Mittelwert schnell und in Echtzeit bildbar ist. Bei einer vorteilhaften Ausgestaltung kann vorgesehen sein, dass mit dem gleitenden Clock-Mittelwertbilder ein gleitender Mittelwert eines aus dem Manchester-kodierten Signal abgeleiteten Signals über einen Clock-Mittelwertzeit bildbar ist. Von Vorteil ist dabei, dass der im Verfahren benötigte gleitende Clock-Mittelwert einfach bildbar ist.

Bei einer vorteilhaften Ausgestaltung kann vorgesehen sein, dass mit dem gleitenden EOT-Mittelwertbilder ein gleitender Mittelwert des Manchester-kodierten Signals über eine EOT-Mittelwertzeit bildbar ist. Auch in diesem Fall ist ein Mittelwertbilder vorteilhaft zur Berechnung des gleitenden Mittelwertes einsetzbar.

Die hierbei verwendeten Mittelwertzeiten sind vorzugsweise wie zuvor zum Dekodierungsverfahren beschrieben gewählt.

Bei einer vorteilhaften Ausgestaltung kann vorgesehen sein, dass eine Verknüpfungseinrichtung zur logischen Verknüpfung eines Ausgangssignals des Daten-Komparators mit einem Ausgangssignal des Clock-Komparators eingerichtet ist. Hierbei kann vorgesehen sein, dass der Clock-Signalflussweg von einem Signalausgang der Verknüpfungseinrichtung zu dem Clock-Signalausgang geführt ist. Von Vorteil ist dabei, dass ein einfaches Verfahren, das Clock-Signal ohne Phasenregelschleife zu rekonstruieren oder dekodieren, realisierbar ist. Bevorzugt realisiert die Verknüpfungseinheit eine XOR-Verknüpfung.

Bei einer vorteilhaften Ausgestaltung kann vorgesehen sein, dass die Mittelwertbilder zur Bildung oder Berechnung eines Differenzsignals eingerichtet sind, wobei das Differenzsignal symbolweise die Differenz von Symbolen des Manchester-kodierten Signals zu einem zu dem jeweiligen Symbol um eine vorgegebene Zeitdauer zeitversetzten Symbol ausdrückt. Von Vorteil ist dabei, dass ein aus dem Manchester-kodierten Signal abgeleitetes Signal bereitgestellt ist, welches zur Mittelwertbildung durch Integration oder auf andere Weise weiterverarbeitbar ist.

Erfindungsgemäß ist vorgesehen, dass der Daten-Komparator zur Ausgabe eines Ausgangssignals in Abhängigkeit von einem Überschreiten oder Unterschreiten wenigstens eines Daten-Schwellwerts, hierbei zur Ausgabe eines Ausgangssignals in Abhängigkeit von einem Überschreiten eines oberen Daten-Schwellwerts des wenigstens einen Daten-Schwellwerts und einem Unterschreiten eines unteren Daten-Schwellwerts des wenigstens einen Daten-Schwellwerts, eingerichtet ist. Von Vorteil ist dabei, dass ein einfaches Mittel zur Erzeugung eines binären Daten-Signals ausgebildet ist. Durch die Ausbildung eines oberen Daten-Schwellwerts und separaten eines unteren Daten-Schwellwerts ist eine Hysterese bei der Umwandlung in ein binäres Signal realisierbar, welche ein zu häufiges Umschalten aufgrund von Störungen unterdrückt.

Bei einer vorteilhaften Ausgestaltung kann vorgesehen sein, dass der Clock-Komparator zur Ausgabe eines Ausgangssignals in Abhängigkeit von einem Überschreiten oder Unterschreiten wenigstens eines Clock-Schwellwerts, insbesondere zur Ausgabe eines Ausgangssignals in Abhängigkeit von einem Überschreiten eines oberen Clock-Schwellwerts des wenigstens einen Clock-Schwellwerts und/oder einem Unterschreiten eines unteren Clock-Schwellwerts des wenigstens einen Clock-Schwellwerts, eingerichtet ist. Von Vorteil ist dabei, dass ein weiterverarbeitbares, binäres Ausgangssignal bereitgestellt ist.

Erfindungsgemäß ist vorgesehen, dass der EOT-Komparator zur Ausgabe eines Ausgangssignals in Abhängigkeit von einem Überschreiten oder Unterschreiten wenigstens eines EOT-Schwellwerts eingerichtet ist. Bevorzugt ist der EOT-Komparatorzur Ausgabe eines Ausgangssignals in Abhängigkeit von einem Überschreiten des oberen EOT-Schwellwerts des wenigstens einen EOT-Schwellwerts und/oder einem Unterschreiten eines unteren EOT-Schwellwerts des wenigstens einen EOT-Schwellwerts einge-richtet ist. Von Vorteil ist dabei, dass das Übertragungsende auf einfache Weise binär erkennbar ist.

Bei einer vorteilhaften Ausgestaltung kann vorgesehen sein, dass die Komparatoren jeweils als Schmidt-Trigger ausgebildet sind.

Bei einer vorteilhaften Ausgestaltung kann vorgesehen sein, dass die Dekodiereinrichtung zur gleichzeitigen und/oder zeitlich parallelen Bildung der gleitenden Daten-, Clock- und/oder EOT-Mittelwerte eingerichtet ist. Von Vorteil ist dabei, dass eine parallele Verarbeitung zeitsparend ausführbar ist.

Bei einer vorteilhaften Ausgestaltung kann vorgesehen sein, dass der gleitende Daten-, Clock- und/oder EOT-Mittelwert mit einer Sampling-Rate bildbar ist/sind, die jeweils kleiner als die oder eine Bitzeit, insbesondere kleiner als 1/10 oder 1/100, des oder eines Clock-Signals des Manchester-kodierten Signals ist. Von Vorteil ist dabei, dass eine feinstufige Abtastung des empfangenen Manchester-kodierten Signals möglich ist.

Bei einer vorteilhaften Ausgestaltung kann vorgesehen sein, dass die Dekodiereinrichtung zur zeitgleichen Bildung des gleitenden Daten-, Clock- und/oder EOT-Mittelwerts mit der Bereitstellung weiterer Symbole des Manchester-kodierten Signals eingerichtet ist. Von Vorteil ist dabei, dass das dekodierte Daten-Signal bereitstellbar ist, bevor die Manchester-kodierte Nachricht vollständig empfangen ist.

Bei einer Ausgestaltung der Erfindung kann vorgesehen sein, dass zwischen dem EOT-Komparator und dem Daten-Komparator und/oder dem Daten-Mittelwertbilder eine Steuerverbindung ausgebildet ist. Von Vorteil ist dabei, dass der Daten-Komparator und/oder der Daten-Mittelwertbilder nach einem erkannten Übertragungsende in einen Startzustand zurückversetzbar sind. So sind Startsequenzen im Daten-Signal verzichtbar.

Weitere Vorteile ergeben sich aus den Unteransprüchen. Die Erfindung ist nicht auf die Merkmalskombination der Ansprüche beschränkt.

**Die** Erfindung wird nun anhand von Abbildungen näher erläutert:
In der Figur 1 ist in stark vereinfachender Weise als Prinzipdarstellung die Erzeugung eines Manchester-kodierten Signals gezeigt.
Figur 2 zeigt ein stark vereinfachtes Blockschaltbild einer erfindungsgemäßen Dekodiereinrichtung zur Erläuterung des erfindungsgemäßen Dekodierungsverfahrens.
Figur 3 zeigt in einer Prinzipskizze die Funktionsweise eines Mittelwertbilders gemäß der Erfindung.
Figur 4 zeigt beispielhaft Signalverläufe zur Erläuterung des erfindungsgemäßen Verfahrens und des Funktionsprinzips der erfindungsgemäßen Dekodiereinrichtung.
Figur 5 zeigt eine weitere erfindungsgemäße Dekodiereinrichtung zur Erläuterung eines vereinfachten erfindungsgemäßen Dekodierungsverfahrens.
Figur 6 zeigt beispielhaft Signalverläufe zur Erläuterung des erfindungsgemäßen Verfahrens und des Funktionsprinzips der erfindungsgemäßen Dekodiereinrichtung nach Figur 5, wobei das empfangene Manchester-kodierte Signal eine Störung aufweist.
Figur 7 zeigt eine weitere erfindungsgemäße Dekodiereinrichtung zur Erläuterung eines vereinfachten erfindungsgemäßen Dekodierungsverfahrens bei welcher ein EOT-Signal zur Rücksetzung der erfindungsgemäßen Dekodiereinrichtung verwendbar ist.

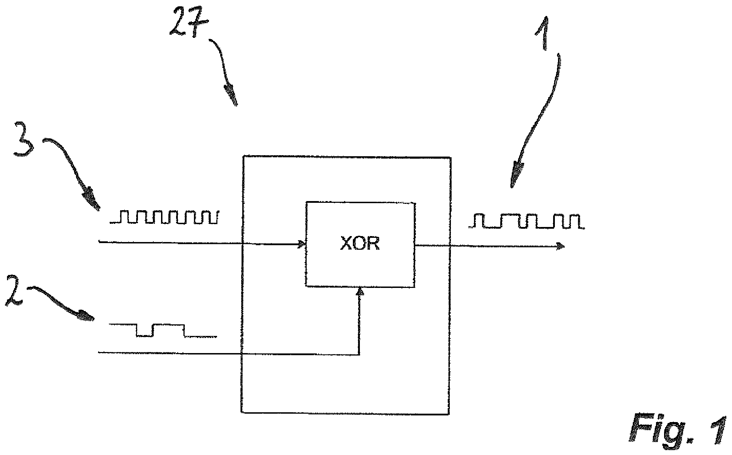

Figur 1 zeigt zur Erläuterung des allgemeinen technologischen Hintergrunds die Erstellung eines Manchester-kodierten Signals 1 mit einer Kodiereinrichtung 27. Dieses Manchester-kodierte Signal 1 entsteht durch XOR-Verknüpfung aus einem ursprünglichen Daten-Signal 2 und einem ursprünglichen Clock-Signal 3 in an sich bekannter Weise.

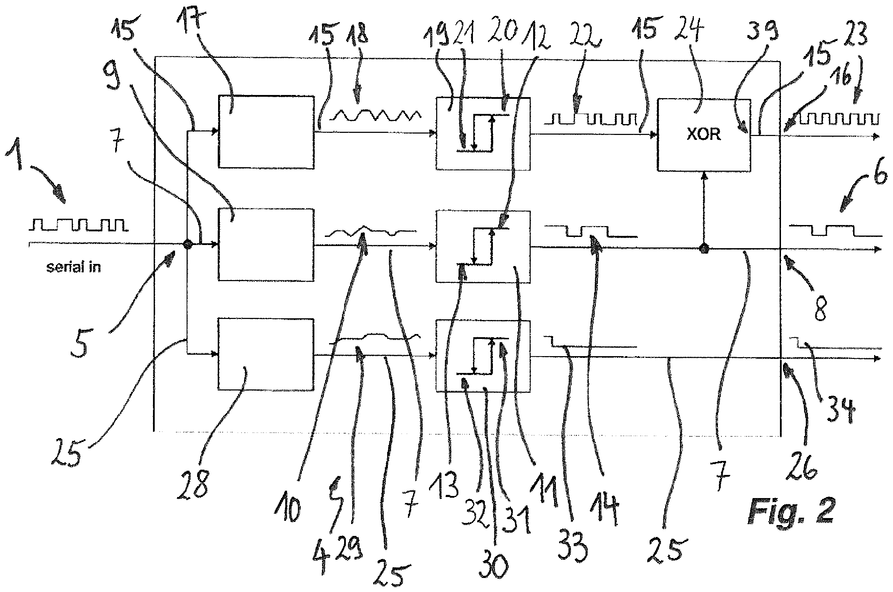

Das Manchester-kodierte Signal 1 wird einem Empfänger zugestellt und von diesem einer in Figur 2 gezeigten, im Ganzen mit 4 bezeichneten Dekodierungseinrichtung zugeführt. Das Manchester-kodierte Signal 1 liegt somit an einem Signaleingang 5 der Dekodierungseinrichtung 4 an.

Die Dekodierungseinrichtung 4 erzeugt aus dem Manchester-kodierten Signal 1 ein dekodiertes Daten-Signal 6, wie im Folgenden näher erläutert wird.

Zur Verarbeitung des Manchester-kodierten Signals 1 ist ein Daten-Signalflussweg 7 ausgebildet, welcher den Signaleingang 5 mit einem Daten-Signalausgang 8 verbindet.

In dem Daten-Signalflussweg 7 ist in Signalflussrichtung zu Beginn ein gleitender Daten-Mittelwertbilder 9 angeordnet, mit welchem aus dem Manchester-kodierten Signal 1 ein gleitender Daten-Mittelwert 10 berechnet wird. Hierbei wird der gleitende Daten-Mittelwert 10 bezüglich einer Daten-Mittelwertzeit gebildet, die gleich der Bitzeit, also der Periode des ursprünglichen Clocks-Signals 3 ist.

In Signalflussrichtung hinter dem gleitenden Daten-Mittelwertbilder 9 ist im Daten-Signalflussweg 7 ein Daten-Komparator 11 angeordnet, welchem der gleitende Daten-Mittelwert 10 zugeführt wird.

In dem Daten-Komparator 11 sind ein unterer Daten-Schwellwert 12 und ein oberer Daten-Schwellwert 13 hinterlegt.

Der Daten-Komparator 11 erzeugt ein Ausgangssignal 14, welches davon abhängt, ob der gleitende Daten-Mittelwert 10 den oberen Daten-Schwellwert 13 überschreitet oder den unteren Daten-Schwellwert 12 unterschreitet. Unterschreitet der gleitende Daten-Mittelwert 10 den unteren Daten-Schwellwert 12, so wird eine logische Null ausgegeben. Überschreitet der gleitende Daten-Mittelwert 10 den oberen Daten-Schwellwert 13, so wird eine logische Eins ausgegeben.

Das Ausgangssignal 14 des Daten-Komparators 11 wird am Daten-Signalausgang 8 als dekodiertes Daten-Signal 6 ausgegeben.

In der Dekodiereinrichtung 4 ist weiter ein Clock-Signalflussweg 15 ausgebildet, welcher den Signaleingang 5 mit einem Clock-Signalausgang 16 verbindet.

In dem Clock-Signalflussweg 15 ist zu Beginn in Signalflussrichtung ein gleitender Clock-Mittelwertbilder 17 angeordnet, mit welchem aus dem Manchester-kodierten Signal 1 ein gleitender Clock-Mittelwert 18 gebildet wird.

Die Funktionsweise des gleitenden Clock-Mittelwertbilders 17 ist analog zu der Funktionsweise des gleitenden Daten-Mittelwertbilders 9, mit dem Unterschied, dass in dem gleitenden Clock-Mittelwertbilder eine Clock-Mittelwertzeit eingestellt ist, die gleich einer halben Bitzeit des ursprünglichen Clock-Signals 3 ist.

Der gleitende Clock-Mittelwert 18 wird einem Clock-Komparator 19 zugeführt.

Der Clock-Komparator 19 funktioniert analog zu dem Daten-Komparator 11, mit dem Unterschied, dass ein abweichender unterer Clock-Schwellwert 20 und ein anderer oberer Clock-Schwellwert 21 festgelegt sind.

Allgemein kann bei diesem Ausführungsbeispiel gesagt werden, dass der untere Daten-Schwellwert 12 gegeben ist durch den Ausdruck 0,25 + D, während der obere Daten-Schwellwert 13 gegeben ist durch den Wert 0,75 - D. Hierbei ist D eine Zahl zwischen -0,25 und +0,25. Es ist ersichtlich, dass das arithmetische Mittel des unteren Daten-Schwellwerts 12 und des oberen Daten-Schwellwerts 13 unabhängig von der Wahl von D bei 0,5 liegt.

Als unterer Clock-Schwellwert 20 ist dagegen bei diesem Ausführungsbeispiel der Wert 0,25 - H festgelegt, während der obere Clock-Schwellwert 21 bei 0,25 + H definiert ist. Hierbei ist H eine Zahl zwischen 0 (inklusive) und +0,25 (exklusive). Es ist ersichtlich, dass das arithmetische Mittel von unterem Clock-Schwellwert 20 und oberem Clock-Schwellwert 21 kleiner ist als das zuvor genannte arithmetische Mittel der Daten-Schwellwerte. Genauer gesagt, liegt dieses arithmetische Mittel der Clock-Schwellwerte im Ausführungsbeispiel bei 0,25.

Bei weiteren erfindungsgemäßen Ausführungsbeispielen müssen die oberen und unteren Schwellwerte nicht notwendig symmetrisch bezüglich eines Mittelwerts verschoben sein.

Eine vorteilhafte Wahl ergibt sich für H = 1/12 und/oder D = 1/12. Besonders bevorzugt ist die Wahl H = D= 1/12. Auf diese Weise wird ein relativ guter Kompromiss zwischen der Filterung der Spikes und einer Frequenztoleranz erreicht. Diese Wahl ist bei dem vorliegenden Ausführungsbeispiel und bei dem nachfolgend weiter beschriebenen Ausführungsbeispiel verwirklicht.

Bei weiteren Ausführungsbeispielen sind andere Werte für H und D realisiert. Beispielsweise kann H = 1/12 sein, während D auf einen anderen Wert festgesetzt ist. Es kann auch sein, dass D = 1/12 ist, während H auf einen anderen Wert festgesetzt ist. Schließlich können sowohl H als auch D auf andere Werte festgesetzt sein, als 1/12. Beispielsweise kann generell H = D ≠ 1/12 festgesetzt sein. Es sind für H und/oder D auch Werte im Bereich zwischen 0,06 und 0,1, insbesondere im Bereich zwischen 0,07 und 0,09, mit Vorteil verwendbar.

Aus dem Ausgangssignal 22 des Clock-Komparators 19 wird ein Clock-Signal 23 gebildet und am Clock-Signalausgang 16 bereitgestellt.

Hierzu wird das Ausgangssignal 22 des Clock-Komparators 19 einer Verknüpfungseinrichtung 24 zugeführt.

In der Verknüpfungseinrichtung 24 ist eine logische XOR-Verknüpfung des Ausgangssignals 22 des Clock-Komparators 19 mit dem Ausgangssignal 14 des Daten-Komparators 11, also dem rekonstruierten Daten-Signal 6 realisiert.

Die Verknüpfungseinrichtung 24 ist somit in Signalflussrichtung hinter dem Clock-Komparator 19 im Clock-Signalflussweg 15 angeordnet.

Die Dekodierungseinrichtung 4 weist weiter einen EOT-Signalflussweg 25 auf, der zwischen dem Signaleingang 5 und einem EOT-Signalausgang 26 veräuft.

In dem EOT-Signalflussweg 25 ist in Signalflussrichtung zu Beginn ein gleitender EOT-Mittelwertbilder 28 angeordnet, der analog zu dem gleitenden Daten-Mittelwertbilder 9 und dem gleitenden Clock-Mittelwertbilder 17 arbeitet. Bei dem gleitenden EOT-Mittelwertbilder 28 ist die Mittelwertbildung jedoch bezüglich einer EOT-Mittelwertzeit ausgeführt, welche größer als die Daten-Mittelwertzeit im gleitenden Daten-Mittelwertbilder 9 und als die Clock-Mittelwertzeit im gleitenden Clock-Mittelwertbilder 17 gewählt ist. Im Ausführungsbeispiel ist die EOT-Mittelwertzeit zu 1,5 Bitzeiten des Clock-Signals 3 gewählt.

Der gleitende EOT-Mittelwertbilder 28 erzeugt somit aus dem Manchester-kodierten Signal 1 einen gleitenden EOT-Mittelwert 29, welcher im EOT-Signalflussweg 25 einem EOT-Komparator 30 zugeführt wird.

Der EOT-Komparator 30 arbeitet in analoger Weise wie der Daten-Komparator 11 und der Clock-Komparator 19. An dem EOT-Komparator 30 sind ein unterer EOT-Schwellwert 31 und ein oberer EOT-Schwellwert 32 vorgegeben, welche von den Schwellwerten des Daten-Komparators 11 und des Clock-Komparators 19 abweichen können. Der untere EOT-Schwellwert 31 und der obere EOT-Schwellwert 32 sind so gewählt, dass ein gewünschtes Hystereseverhalten des EOT-Komparators 30 bei der Erzeugung des binären Ausgangssignals 33 erreicht ist.

Besonders günstig ist es, wenn der obere EOT-Schwellwert 32 gleich dem unteren EOT-Schwellwert 31 gewählt ist. Beispielsweise können beiden EOT-Schwellwerte 31, 32 in dem Bereich zwischen 0 und 0,5 festgelegt sein, bevorzugt gleich 0,25.

Dieses Ausgangssignal 33 des EOT-Komparators 30 wird am EOT-Signalausgang 26 als EOT-Signal 34 ausgegeben.

Gegebenenfalls ist im EOT-Signalflussweg 25 hinter dem EOT-Komparator 30 ein nicht weiter dargestellter Invertierer angeordnet.

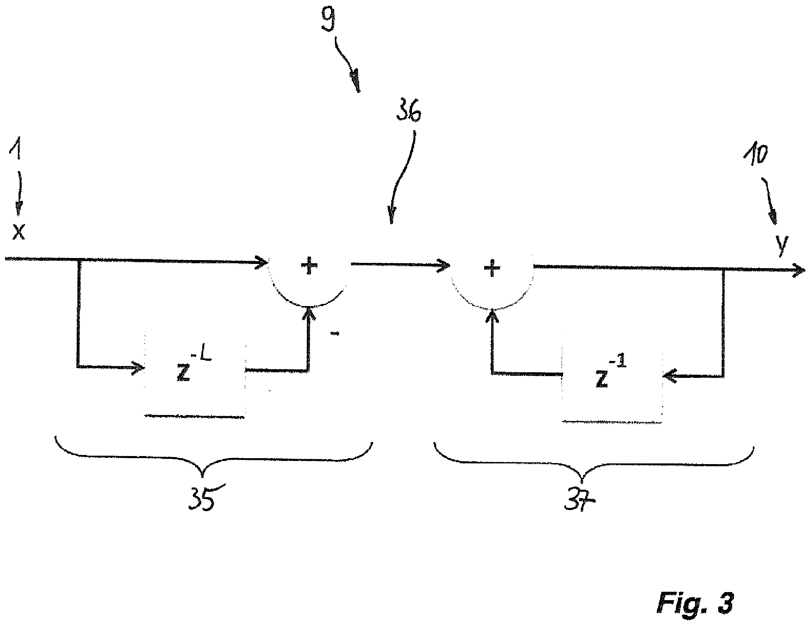

In Figur 3 ist beispielhaft für den Fall des gleitenden Daten-Mittelwertbilders 9 die Funktionsweise der Mittelwertbilder 9, 17, 28 der Dekodierungseinrichtung 4 näher erläutert.

Dem gleitenden Daten-Mittelwertbilder 9 wird das Manchester-kodierte Signal 1 zugeführt.

In einer Differenzstufe 35 wird aus dem Manchester-kodierten Signal 1 ein abgeleitetes Signal 36 in Form eines Differenzsignals abgeleitet. Hierzu wird für die einzelnen Symbole x des Manchester-kodierten Signals 1 jeweils die Differenz des Symbols x zu einem zu diesem Symbol x um eine vorgegebene Zeitdauer L zeitversetzten Symbol in dem Manchester-kodierten Signal 1 gebildet.

Das abgeleitete Signal 36 wird anschließend einer Integrationsstufe 37 zugeführt, in welcher das abgeleitete Signal 36 aufintegriert wird. Der gleitende Daten-Mittelwertbilder 9 stellt somit einen gleitenden Daten-Mittelwert 10 bereit, welcher aus Symbolen y zusammengesetzt ist.

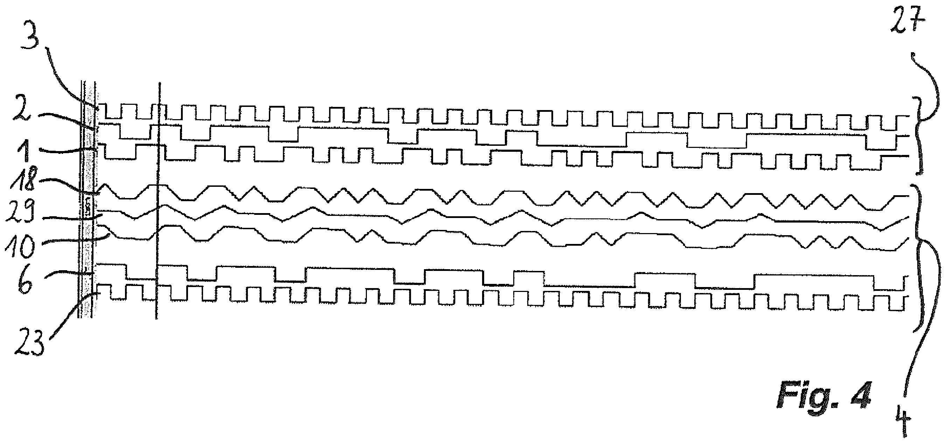

Figur 4 zeigt beispielhaft einen Signalverlauf an der Kodiereinrichtung 27 und der Dekodierungseinrichtung 4.

In der Kodiereinrichtung 27 wird zu dem eingegebenen ursprünglichen Daten-Signal 2 und einem in der Kodiereinrichtung 27 erzeugten ursprünglichen Clock-Signal 3 ein Manchester-kodiertes Signal 1 erzeugt.

Dieses Manchester-kodierte Signal 1 wird an die Dekodierungseinrichtung 4 übertragen.

In der Dekodierungseinrichtung 4 werden - wie beschrieben - ein gleitender Daten-Mittelwert 10, ein gleitender Clock-Mittelwert 18 und ein gleitender EOT-Mittelwert 29 aus dem Manchester-kodierten Signal 1 gebildet.

Es ist ersichtlich, dass diese Mittelwerte nicht binär sind, sondern sehr feingestuft, nahezu analog.

Mit den erwähnten Komparatoren wird aus dem gleitenden Daten-Mittelwert 10 das dekodierte Daten-Signal 6 erzeugt. Mit diesem Daten-Signal 6 und dem gleitenden Clock-Mittelwert 18 wird durch den beschriebenen Schwellwertvergleich im Clock-Komparator 19 und durch die ebenfalls beschriebene logische Verknüpfung in der Verknüpfungseinrichtung 24 ein Clock-Signal 23 erzeugt und ausgegeben. Es ist ersichtlich, dass das Clock-Signal 23 dieselbe Bitzeit wie das ursprüngliche Clock-Signal 3 aufweist, dass aber die dekodierten Signale 6, 23 gegenüber den ursprünglichen Signalen 2, 3 zeitversetzt sind.

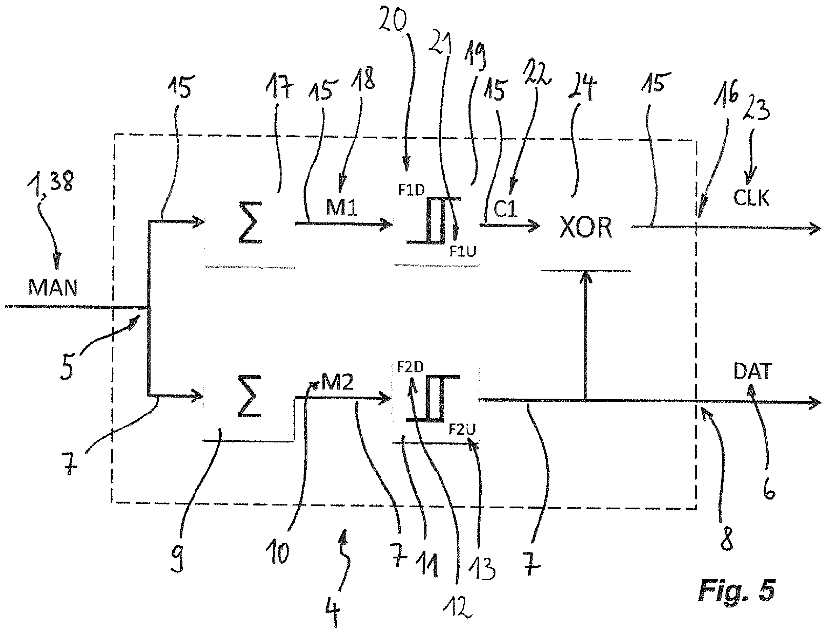

Figur 5 zeigt ein weiteres erfindungsgemäßes Ausführungsbeispiel einer Dekodierungseinrichtung 4.

Bei der Dekodierungseinrichtung 4 gemäß Figur 5 sind funktionell und/oder konstruktiv zu der Dekodierungseinrichtung gemäß Figur 2 gleiche oder ähnliche Bauteile mit demselben Bezugszeichen bezeichnet und nicht noch einmal gesondert beschrieben. Die dort erläuterten Ausführungen gelten für die Dekodierungseinrichtung 4 gemäß Figur 5 entsprechend.

Im Unterschied zu dem Ausführungsbeispiel gemäß Figur 2 ist bei der Dekodierungseinrichtung 4 gemäß Figur 5 kein EOT-Signalflussweg ausgebildet.

Vielmehr weist die Dekodierungseinrichtung 4 nur einen Daten-Signalflussweg 7 und einen Clock-Signalflussweg 15 auf, die in der zu Figur 2 und Figur 3 beschriebenen Weise arbeiten.

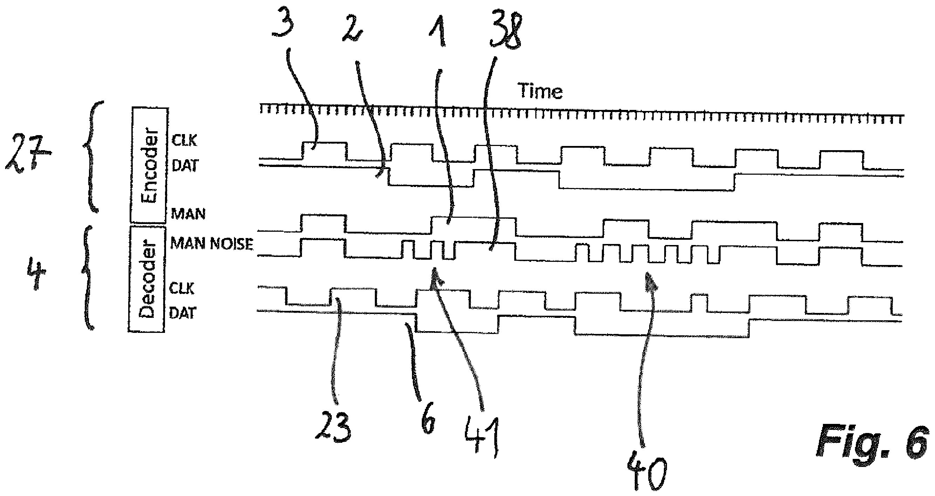

Figur 6 zeigt einen typischen Signalverlauf beispielhaft für die Dekodierungseinrichtung 4 gemäß Figur 5.

Wie bereits zu Figur 4 erläutert, wird in der Kodiereinrichtung 27 ein Manchester-kodiertes Signal 1 aus einem ursprünglichen Daten-Signal 2 und einem ursprünglichen Clock-Signal 3 erzeugt.

Dieses Manchester-kodierte Signal 1 wird an die Dekodierungseinrichtung 4 übertragen.

Zur Erläuterung der Robustheit des erfindungsgemäßen Verfahrens sei angenommen, dass bei der Übertagung das Manchester-kodierte Signal 1 durch Rauschen mit höherfrequenten Störungen 40, 41 gestört ist.

An der Dekodierungseinrichtung 4 wird daher ein gestörtes Manchester-kodiertes Signal 38 empfangen.

Aus dem gestörten Manchester-kodierten Signal 38 bildet die Dekodierungseinrichtung 4 in analoger Weise zu den Erläuterungen zu Figur 1 bis 4 ein dekodiertes Daten-Signal 6 und ein dekodiertes Clock-Signal 23.

Es ist ersichtlich, dass die Störungen 40 und 41 eine temporär fehlerhafte Bit-Zeit des Clock-Signals 23 bewirken, die jedoch sehr schnell wieder auf die tatsächliche Bitzeit des ursprünglichen Clock-Signals 3 zurückkehrt.

Es ist weiter ersichtlich, dass das Clock-Signal 23 synchron mit dem Daten-Signal 6 umschaltet, so dass auch bei temporär geringfügig fehlerhaften Bitzeiten des Clock-Signals 23 das Daten-Signal 6 richtig interpretierbar ist.

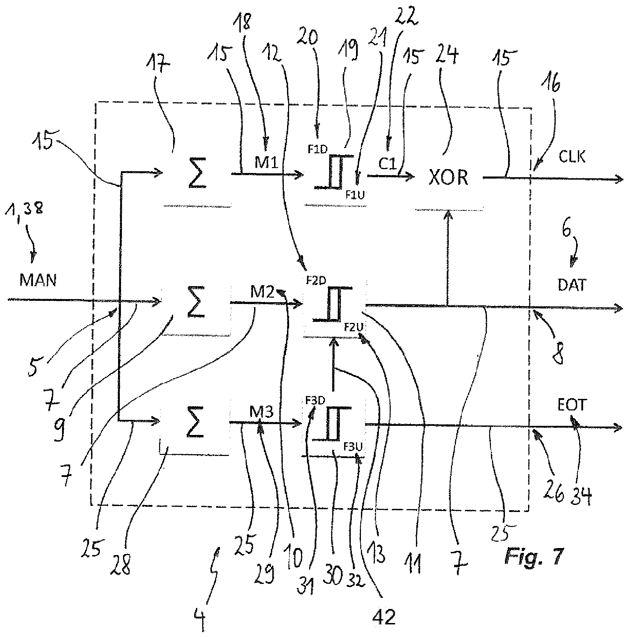

Figur 7 zeigt ein weiteres erfindungsgemäßes Ausführungsbeispiel einer Dekodierungseinrichtung 4.

Bei der Dekodierungseinrichtung 4 gemäß Figur 7 sind funktionell und/oder konstruktiv zu der Dekodierungseinrichtung gemäß Figur 2 und/oder 5 gleiche oder ähnliche Bauteile mit demselben Bezugszeichen bezeichnet und nicht noch einmal gesondert beschrieben. Die dort erläuterten Ausführungen gelten für die Dekodierungseinrichtung 4 gemäß Figur 7 entsprechend.

Bei der Dekodiereinrichtung 4 ist zusätzlich zu dem Ausführungsbeispiel nach Figur 2 eine Steuerverbindung 42 zwischen dem EOT-Komparator 30 und dem Daten-Komparator 11 ausgebildet. Die Dekodiereinrichtung 4 ist so eingerichtet, dass die Daten-Schwellwerte 12, 13 im Daten-Komparator 11 auf Standardwerte zurücksetzbar sind oder zurückgesetzt werden, wenn in dem EOT-Komparator 30 ein Übertragungsende detektiert ist oder wird. Somit ist die Empfindlichkeit des Daten-Komparators 11 nach der vollständigen DatenÜbertragung zurücksetzbar und wird zurückgesetzt, um die Dekodiereinrichtung 4 zum erneuten Datenempfang vorzubereiten.

Bei weiteren Ausführungsbeispielen ist alternativ oder zusätzlich eine Steuerverbindung zwischen dem EOT-Komparator 30 und dem gleitenden Daten-Mittelwertbilder 9 ausgebildet. Bei diesen Ausführungsbeispielen kann somit die Mittelwertbildung bei erneuter Datenübertragung von einem definierten Startwert aus erfolgen. Es ist so beispielsweise die Dekodierung des Eingangssignals vom Signaleingang 5 sperrbar und gesperrt, solange der EOT-Komparator 30 noch keine Signalübertragung erkannt hat. Logische Sequenzen zur Markierung des Signalanfangs sind verzichtbar.

Es sei zu Figur 3 noch erwähnt, dass die Zeitdauer L in der Differenzstufe 35 die jeweilige Mittelwertzeit des gleitenden Daten-Mittelwertbilders 9, des gleitenden Clock-Mittelwertbilders 17 und des gleitenden EOT-Mittelwertbilders 28 definieren.

Aus den Figuren 4 und 6 ist ersichtlich, dass die gleitenden Mittelwerte 10, 18, 29 gleichzeitig und zeitlich parallel zueinander fortlaufend gebildet werden, während zeitgleich weitere Symbole x des Manchester-kodierten Signals 1 am Signaleingang 5 bereitgestellt werden. Die Bildung des Daten-Signals 6 und des Clock-Signals 23 und gegebenenfalls des EOT-Signals 34 erfolgen daher in Echtzeit synchron mit dem Takt des Manchester-kodierten Signals 1.

Der Arbeitstakt der Dekodierungseinrichtung 4 ist durch eine Sampling-Rate vorgegeben, mit welcher die erwähnten Mittelwerte 10, 18, 29 in den Mittelwertbildern 9, 17, 28 erzeugt werden. Bei dem vorgestellten Ausführungsbeispiel wird eine Sampling-Rate verwendet welche 256 Abtastungen je Bitzeit des Clock-Signals 3 aufnimmt. Bei weiteren Ausführungsbeispielen sind andere Sampling-Raten realisiert.

Es sei noch erwähnt, dass die hier beschriebenen Verfahren auch auf invertiert gesendete Eingangssignale übertragbar sind. In einem solchen Fall muss die a priori bekannte Startfolge des Manchester-kodierten Signals 1 angepasst werden. Ebenso kann die Anwendung auf die Übertragung mit einem Idle-Zustand 1 übertragen werden.

Bei der Dekodiereinrichtung 4 für ein Manchester-kodiertes Signal 1 wird vorgeschlagen, mit gleitenden Mittelwertbildern 9, 17, 28 wenigstens einen gleitenden Daten-Mittelwert 10 und/oder einen gleitenden Clock-Mittelwert 18 bezüglich zueinander verschiedener Mittelwertzeiten zu bilden und aus diesen gleitenden Mittelwerten 10, 18, 29 mittels Komparatoren 11, 19, 30 bimäre Ausgangssignale als Daten-Signal 6 und/oder Clock-Signal 23 bereitzustellen.

### Bezugszeichenliste

- 1: Manchester-kodiertes Signal
- 2: ursprüngliches Daten-Signal
- 3: ursprüngliches Clock-Signal
- 4: Dekodierungseinrichtung
- 5: Signaleingang
- 6: Daten-Signal
- 7: Daten-Signalflussweg
- 8: Daten-Signalausgang
- 9: gleitender Daten-Mittelwertbilder
- 10: gleitender Daten-Mittelwert
- 11: Daten-Komparator
- 12: unterer Daten-Schwellwert
- 13: oberer Daten-Schwellwert
- 14: Ausgangssignal
- 15: Clock-Signalflussweg
- 16: Clock-Signalausgang
- 17: gleitender Clock-Mittelwertbilder
- 18: gleitender Clock-Mittelwert
- 19: Clock-Komparator
- 20: unterer Clock-Schwellwert
- 21: oberer Clock-Schwellwert
- 22: Ausgangssignal
- 23: Clock-Signal
- 24: Verknüpfungseinrichtung
- 25: EOT-Signalflussweg
- 26: EOT-Signalausgang
- 27: Kodiereinrichtung
- 28: gleitender EOT-Mittelwertbilder
- 29: gleitender EOT-Mittelwert
- 30: EOT-Komparator
- 31: unterer EOT-Schwellwert
- 32: oberer EOT-Schwellwert
- 33: Ausgangssignal
- 34: EOT-Signal
- 35: Differenzstufe
- 36: abgeleitetes Signal
- 37: Integrationsstufe
- 38: gestörtes Machester-kodiertes Signal
- 39: Signalausgang
- 40: Störung
- 41: Störung
- 42: Steuerverbindung
- x: Symbol
- y: Symbol
- L: Zeitdauer

## Patentansprüche

1. Dekodierungsverfahren für ein Manchester-kodiertes Signal,
wobei
für das Manchester-kodierte Signal (1) ein gleitender Daten-Mittelwert (10) mit einer Daten-Mittelwertzeit gebildet wird und
aus dem gleitenden Daten-Mittelwert (10) mit einem Daten-Komparator (11) ein dekodiertes Daten-Signal (6) gebildet und bereitgestellt wird,
**dadurch gekennzeichnet,**
**dass** für das Manchester-kodierte Signal (1) ein gleitender EOT(end of transmission, Übertragungsende)-Mittelwert (29) mit einer EOT-Mittelwertzeit gebildet wird,
**dass** die EOT-Mittelwertzeit länger als die Daten-Mittelwertzeit ist,
**dass** aus dem gleitenden EOT-Mittelwert (29) mit einem EOT-Komparator (30) ein EOT-Signal (34) gebildet und bereitgestellt wird,
**dass** der EOT Komparator (30) das EOT-Signal (34) in Abhängigkeit von einem Überschreiten oder Unterschreiten wenigstens eines EOT-Schwellwerts (31, 32) ausgibt,
**dass** der Daten-Komparator (11) den gleitenden Daten-Mittelwert (10) mit wenigstens einem Daten-Schwellwert (12, 13) vergleicht und das dekodierte Daten-Signal (6) in Abhängigkeit von einem Überschreiten oder Unterschreiten des wenigstens einen Daten-Schwellwerts (12, 13) ausgibt,
der wenigstens eine Daten-Schwellwert (12, 13) einen unteren Daten-Schwellwert (12) und einen oberen Daten-Schwellwert (13) umfasst und der Daten-Komparator (11) das dekodierte Daten-Signal (6) in Abhängigkeit von einem Überschreiten des oberen Daten-Schwellwerts (13) und einem Unterschreiten des unteren Daten-Schwellwerts (12) ausgibt und
**dass** über eine zwischen dem EOT-Komparator (30) und dem Daten-Komparator (11) ausgebildete Steuerverbindung (42) der wenigstens eine Daten-Schwellwert (12, 13) im Daten-Komparator (11) auf Standardwerte zurückgesetzt wird, wenn in dem EOT-Komparator (30) ein Übertragungsende detektiert wird,
und/oder
**dass** über eine zwischen dem EOT-Komparator (30) und dem gleitenden Daten-Mittelwertbilder (9) und/oder einem gleitenden Clock-Mittelwertbilder (17) ausgebildete Steuerverbindung der Daten-Mittelwertbilder (9) und/oder der Clock-Mittelwertbilder (17) zurückgesetzt wird oder werden, wenn in dem EOT-Komparator (30) ein Übertragungsende detektiert wird.

2. Dekodierungsverfahren nach dem vorangegangenen Anspruch,
**dadurch gekennzeichnet,**
**dass** für das Manchester-kodierte Signal (1) ein gleitender Clock-Mittelwert (18) mit einer Clock-Mittelwertzeit gebildet wird
und **dass** zumindest aus dem gleitenden Clock-Mittelwert (18) mit einem Clock-Komparator (19) ein Clock-Signal (23) gebildet und bereitgestellt wird,
insbesondere wobei die EOT-Mittelwertzeit länger als die Clock-Mittelwertzeit ist.

3. Dekodierungsverfahren nach dem vorangegangenen Anspruch,
**dadurch gekennzeichnet,**
**dass** zur Bildung des Clock-Signals (23) ein Ausgangssignal (22) des Clock-Komparators (19) mit dem dekodierten Daten-Signal (6) logisch verknüpft wird.

4. Dekodierungsverfahren nach einem der vorangegangenen Ansprüche,
**dadurch gekennzeichnet,**
**dass** zur Bildung des Clock-Signals (23) das Ausgangssignal (22) des Clock-Komparators (19) mit dem Daten-Signal (6), logisch verknüpft, insbesondere durch XOR-Verknüpfung logisch verknüpft, wird.

5. Dekodierungsverfahren nach einem der Ansprüche 2 bis 4, **dadurch gekennzeichnet,**
**dass** die Clock-Mittelwertzeit kürzer als die Daten-Mittelwertzeit ist
und/oder
**dass** zur Bildung des/der gleitenden Daten- (10), Clock- (18) und/oder EOT-Mittelwerts (29) ein aus dem Manchester-kodierten Signal (1) abgeleitetes Signal (36) über die Daten-, Clock- und/oder EOT-Mittelwertzeit integriert wird.

6. Dekodierungsverfahren nach einem der Ansprüche 2 bis 5, **dadurch gekennzeichnet,**
**dass** zur Bildung des gleitenden Daten- (10), Clock- (18) und/oder EOT-Mittelwerts (29) fortschreitend ein Differenzsignal von Differenzen zwischen jedem Symbol x des Manchester-kodierten Signals und einem zu diesem Symbol x um eine vorgegebene Zeitdauer L zeitversetzten Symbol des Manchester-kodierten Signals (1) als das aus dem Manchester-kodierten Signal (1) abgeleitete Signal (36) gebildet wird.

7. Dekodierungsverfahren nach einem der vorangehenden Ansprüche,
**dadurch gekennzeichnet,**
**dass** ein arithmetischer Mittelwert des unteren Daten-Schwellwerts (12) und des oberen Daten-Schwellwerts (13) zwischen Null und Eins, insbesondere bei 1/2, liegt und/oder
**dass** als Daten-Mittelwertzeit eine Zeitdauer, die größer als eine halbe Bitzeit und/oder kleiner als das 1,5fache der Bitzeit, insbesondere gleich der Bitzeit, eines Clock-Signals (3) des Manchester-kodierten Signals (1) ist, eingerichtet wird.

8. Dekodierungsverfahren nach einem der vorangegangenen Ansprüche,
**dadurch gekennzeichnet,**
**dass** als Clock-Mittelwertzeit eine Zeitdauer, die kleiner als eine Bitzeit, insbesondere gleich der halben Bitzeit, eines Clock-Signals (3) des Manchester-kodierten Signals (1) ist, eingerichtet wird
und/oder
**dass** als EOT-Mittelwertzeit eine Zeitdauer, die größer als eine Bitzeit, insbesondere gleich der 1,5fachen Bitzeit, eines Clock-Signals (3) des Manchester-kodierten Signals (1) ist, eingerichtet wird.

9. Dekodierungsverfahren nach einem der Ansprüche 2 bis 8, **dadurch gekennzeichnet,**
**dass** der Clock-Komparator (19) den gleitenden Clock-Mittelwert (18) mit wenigstens einem Clock-Schwellwert (20, 21) vergleicht und ein Ausgangssignal (22) in Abhängigkeit von einem Überschreiten oder Unter-schreiten des wenigstens einen Clock-Schwellwerts (20, 21) ausgibt.

10. Dekodierungsverfahren nach einem der Ansprüche 2 bis 9, **dadurch gekennzeichnet,**
**dass** der wenigstens eine Clock-Schwellwert (20, 21) einen unteren Clock-Schwellwert (20) und einen oberen Clock-Schwellwert (21) umfasst und dass der Clock-Komparator (19) ein Ausgangssignal (22) in Abhängigkeit von einem Überschreiten des oberen Clock-Schwellwerts (21) und/oder einem Unterschreiten des unteren Clock-Schwellwerts (20) ausgibt.

11. Dekodierungsverfahren nach dem vorangegangenen Anspruch,
**dadurch gekennzeichnet,**
**dass** ein arithmetischer Mittelwert des unteren Clock-Schwellwerts (20) und des oberen Clock-Schwellwerts (21) zwischen Null und Eins, insbesondere unterhalb des arithmetischen Mittelwerts (20) von unterem Daten-Schwellwert (12) und oberem Daten-Schwellwerts (8) und/oder bei 1/4, liegt und/oder dass der gleitende Daten- (10), Clock- (18) und/oder EOT-Mittelwert (29) gleichzeitig und/oder zeitlich parallel zueinander gebildet wird/werden.

12. Dekodierungsverfahren nach einem der Ansprüche 2 bis 11 **dadurch gekennzeichnet**
**dass** der gleitende Daten- (10), Clock- (18) und/oder EOT-Mittelwert (20) mit einer Sampling-Rate gebildet wird/werden, die jeweils kleiner als die oder eine Bitzeit, insbesondere kleiner als ein Zehntel oder ein Hundertstel, des Clock-Signals (3) des Manchester-kodierten Signals (1) ist,
und/oder
**dass** der gleitende Daten- (10), Clock- (18) und/oder EOT-Mittelwert (29) zeitgleich zu einer Bereitstellung weiterer Symbole (x) des Manchester-kodierten Signals (1) gebildet wird/werden.

13. Dekodiereinrichtung (4),
mit einem Signaleingang (5) für ein Manchester-kodiertes Signal (1) und einem Clock-Signalausgang (16) für ein aus dem Manchester-kodierten Signal (1) dekodiertes Clock-Signal (28),
und mit einem Signalausgang (8) für ein Manchester-dekodiertes Signal (6) und einem EOT(end of transmission, Übertragungsende)-Signalausgang (26) für ein aus dem Manchester-kodierten Signal (1) abgeleitetes EOT-Signal (34),
wobei,
ein Daten-Signalflussweg (7) vom Signaleingang (5) zu einem gleitenden Daten-Mittelwertbilder (9),
von diesem zu einem Daten-Komparator (11)
und von diesem zu dem Daten-Signalausgang (8) eingerichtet ist,
und wobei ein EOT-Signalflussweg (25) vom Signaleingang (5) zu einem EOT-Komparator (30)
und von diesem zu dem EOT-Signalausgang (26) eingerichtet ist,
**dadurch gekennzeichnet,**
**dass** der EOT-Signalflussweg (25) vom Signaleingang (5) zu einem gleitenden EOT-Mittelwertbilder (28) und von diesem zu dem EOT-Komparator (30) eingerichtet ist,
**dass** eine EOT-Mittelwertzeit des EOT-Mittelwertbilders (28) länger als eine Daten-Mittelwertzeit des Daten-Mittelwertbilders (9) ist,
**dass** der EOT-Komparator (30) zur Ausgabe des EOT-Signals (34) in Abhängigkeit von einem Überschreiten oder Unterschreiten wenigstens eines EOT-Schwellwerts (31, 32) eingerichtet ist,
**dass** der Daten-Komparator (11) zur Ausgabe eines Ausgangssignals (14) in Abhängigkeit von einem Überschreiten eines oberen Daten-Schwellwerts (13) und einem Unterschreiten eines unteren Daten-Schwellwerts (12) eingerichtet ist,
**dass** eine Steuerverbindung (42) zwischen dem EOT-Komparator (30) und dem Daten-Komparator (11) ausgebildet ist und die Dekodiereinrichtung (4) so eingerichtet ist, dass der obere Daten-Schwellwerte (13) und der untere Daten-Schwellwert (12) im Daten-Komparator (11) auf Standardwerte zurücksetzbar sind oder zurückgesetzt werden, wenn in dem EOT-Komparator (30) ein Übertragungsende detektiert ist oder wird,
und/oder
**dass** eine Steuerverbindung zwischen dem EOT-Komparator (30) und dem gleitenden Daten-Mittelwertbilder (9) und/oder einem gleitenden Clock-Mittelwertbilder (17) ausgebildet ist, und die Steuerverbindung so eingerichtet wird, dass der Daten-Mittelwertbilder (9) und/oder der Clock-Mittelwertbilder (17) zurückgesetzt wird oder werden, wenn in dem EOT-Komparator (30) ein Übertragungsende detektiert wird.

14. Dekodiereinrichtung (4) nach dem vorangegangenen Anspruch,
**dadurch gekennzeichnet,**
**dass** ein Clock-Signalflussweg (15) vom Signaleingang (5) zu einem gleitenden Clock-Mittelwertbilder (17),
von diesem zu einem Clock-Komparator (19)
und von diesem zu dem Clock-Signalausgang (16) eingerichtet ist,
insbesondere wobei
die EOT-Mittelwertzeit länger als eine Clock-Mittelwertzeit des Clock-Mittelwertbilders (17) ist.

15. Dekodiereinrichtung (4) nach Anspruch 14,
**dadurch gekennzeichnet,**
**dass** eine Verknüpfungseinrichtung (24) zur logischen Verknüpfung eines Ausgangssignals (14) des Daten-Komparators (11) mit einem Ausgangssignal (22) des Clock-Komparators (19) eingerichtet ist.

16. Dekodiereinrichtung (4) nach einem der Ansprüche 13 bis 15,
**dadurch gekennzeichnet,**
**dass** mit dem gleitenden Daten-Mittelwertbilder (9) ein gleitender Mittelwert eines aus dem Manchester-kodierten Signal (1) abgeleiteten Signals (36) über eine Daten-Mittelwertzeit bildbar ist.

17. Dekodiereinrichtung (4) nach einem der Ansprüche 14 bis 16,
**dadurch gekennzeichnet,**
**dass** mit dem gleitenden Clock-Mittelwertbilder (17) ein gleitender Mittelwert eines aus dem Manchester-kodierten Signal (1) abgeleiteten Signals (36) über eine Clock-Mittelwertzeit bildbar ist.

18. Dekodiereinrichtung (4) nach einem der Ansprüche 13 bis 17,
**dadurch gekennzeichnet,**
**dass** mit dem gleitenden EOT-Mittelwertbilder (28) ein gleitender Mittelwert eines aus dem Manchester-kodierten Signal (1) abgeleiteten Signals (36) über eine EOT-Mittelwertzeit bildbar ist.

19. Dekodiereinrichtung (4) nach einem der Ansprüche 14 bis 18,
**dadurch gekennzeichnet,**
**dass** der Clock-Signalflussweg (15) von einem Signalausgang (39) der Verknüpfungseinrichtung (24) zu dem Clock-Signalausgang (16) geführt ist.

20. Dekodiereinrichtung (4) nach einem der Ansprüche 14 bis 19,
**dadurch gekennzeichnet,**
**dass** der Clock-Komparator (19) zur Ausgabe eines Ausgangssignals (22) in Abhängigkeit von einem Überschreiten oder Unterschreiten wenigstens eines Clock-Schwellwerts (20, 21), insbesondere zur Ausgabe eines Ausgangssignals (22) in Abhängigkeit von einem Überschreiten eines oberen Clock-Schwellwerts (21) des wenigstens einen Clock-Schwellwertes (20, 21)
und/oder
einem Unterschreiten eines unteren Clock-Schwellwerts (20) des wenigstens einen Clock-Schwellwerts (20, 21),
eingerichtet ist.

21. Dekodiereinrichtung (4) nach einem der Ansprüche 13 bis 20,
dass der EOT-Komparator (30) zur Ausgabe eines Ausgangssignals (33) in Abhängigkeit von einem Überschreiten eines oberen EOT-Schwellwerts (32) des wenigstens einen EOT-Schwellwertes (31, 32)
und/oder
einem Unterschreiten eines unteren EOT-Schwellwerts (31) des wenigstens einen EOT-Schwellwerts (31, 32),
eingerichtet ist.

22. Dekodiereinrichtung (4) nach einem der Ansprüche 13 bis 21,
**dadurch gekennzeichnet,**
**dass** sie zur gleichzeitigen und/oder zeitlich parallelen Bildung der gleitenden Daten- (10), Clock- (18) und/oder EOT-Mittelwerte (29) eingerichtet ist,
insbesondere wobei
der gleitende Daten- (10), Clock- (18) und/oder EOT-Mittelwert (29) mit einer Sampling-Rate bildbar ist/sind,
die jeweils kleiner als die oder eine Bitzeit,
insbesondere kleiner als ein Zehntel oder ein Hundertstel,
des oder eines Clock-Signals (3) des Manchester-kodierten Signals (1) ist,
und/oder
**dass** sie zur zeitgleichen Bildung des gleitenden Daten- (10), Clock- (18) und/oder EOT-Mittelwerts (29) mit der Bereitstellung weiterer Symbole des Manchester-kodierten Signals (1) eingerichtet ist.

## Claims

1. Decoding method for a Manchester-encoded signal,
wherein
a moving data average (10) having a data average time is formed for the Manchester-encoded signal (1) and
a decoded data signal (6) is formed from the moving data average (10) using a data comparator (11) and is made available,
**characterised in that**
a moving end-of-transmission (EOT) average (29) having an EOT average time is formed for the Manchester-encoded signal (1),
**in that** the EOT average time is longer than the data average time,
**in that** an EOT signal (34) is formed from the moving EOT average (29) using an EOT comparator (30) and is made available,
**in that** the EOT comparator (30) outputs the EOT signal (34) depending on whether a result exceeds or falls below at least one EOT threshold (31, 32),
**in that** the data comparator (11) compares the moving data average (10) with at least one data threshold (12, 13) and outputs the decoded data signal (6) depending on whether the result exceeds or falls below the at least one data threshold (12, 13),
the at least one data threshold (12, 13) includes a lower data threshold (12) and an upper data threshold (13) and the data comparator (11) outputs the decoded data signal (6) depending on whether a result exceeds the upper data threshold (13) and falls below the lower data threshold (12), and
**in that** by means of a control connection (42) formed between the EOT comparator (30) and the data comparator (11), the at least one data threshold (12, 13) in the data comparator (11) is reset to standard values if an end of transmission is detected in the EOT comparator (30),
and/or
**in that** by means of a control connection formed between the EOT comparator (30) and the moving-type data averaging unit (9) and/or a moving-type clock averaging unit (17), the data averaging unit (9) and/or the clock averaging unit (17) is/are reset if an end of transmission is detected in the EOT comparator (30).

2. Decoding method according to the preceding claim,
**characterised in that**
a moving clock average (18) having a clock average time is formed for the Manchester-encoded signal (1)
and **in that** a clock signal (23) is formed at least from the moving clock average (18) using a clock comparator (19) and is made available,
in particular wherein the EOT average time is longer than the clock average time.

3. Decoding method according to the preceding claim,
**characterised in that**
to form the clock signal (23), an output signal (22) of the clock comparator (19) is logically linked to the decoded data signal (6).

4. Decoding method according to any of the preceding claims,
**characterised in that**
to form the clock signal (23), the output signal (22) of the clock comparator (19) is logically linked to the data signal (6), in particular is logically linked by an XOR gate.

5. Decoding method according to any of claims 2 to 4,
**characterised in that**
the clock average time is shorter than the data average time
and/or
**in that** to form the moving data average (10), the moving clock average (18) and/or the moving EOT average (29), a signal (36) derived from the Manchester-encoded signal (1) is integrated over the data, clock and/or EOT average time.

6. Decoding method according to any of claims 2 to 5,
**characterised in that**
to form the moving data average (10), the moving clock average (18) and/or the moving EOT average (29), a difference signal of differences between each symbol x of the Manchester-encoded signal and a symbol of the Manchester-encoded signal (1) that is time-shifted relative to said symbol x by a predefined time period is continually formed as the signal (36) derived from the Manchester-encoded signal (1).

7. Decoding method according to any of the preceding claims,
**characterised in that**
an arithmetic average of the lower data threshold (12) and the upper data threshold (13) is between zero and one, in particular is 1/2
and/or
**in that** a time period that is greater than half a bit time and/or smaller than 1.5 times the bit time, in particular is the same as the bit time, of a clock signal (3) of the Manchester-encoded signal (1) is configured as the data average time.

8. Decoding method according to any of the preceding claims,
**characterised in that**
a time period that is smaller than a bit time, in particular is equal to half the bit time, of a clock signal (3) of the Manchester-encoded signal (1) is configured as the clock average time
and/or
**in that** a time period that is greater than a bit time, in particular is equal to 1.5 times the bit time, of a clock signal (3) of the Manchester-encoded signal (1) is configured as the EOT average time.

9. Decoding method according to any of claims 2 to 8,
**characterised in that**
the clock comparator (19) compares the moving clock average (18) with at least one clock threshold (20, 21) and outputs an output signal (22) depending on whether the result exceeds or falls below the at least one clock threshold (20, 21).

10. Decoding method according to any of claims 2 to 9,
**characterised in that**
the at least one clock threshold (20, 21) includes a lower clock threshold (20) and an upper clock threshold (21) and **in that** the clock comparator (19) outputs an output signal (22) depending on whether a result exceeds the upper clock threshold (21) and/or falls below the lower clock threshold (20).

11. Decoding method according to the preceding claim,
**characterised in that**
an arithmetic average of the lower clock threshold (20) and the upper clock threshold (21) is between zero and one, in particular is below the arithmetic average (20) of the lower data threshold (12) and the upper data threshold (8) and/or is 1/4, and/or **in that** the moving data average (10), the moving clock average (18) and/or the moving EOT average (29) is/are formed simultaneously and/or concurrently.

12. Decoding method according to any of claims 2 to 11,
**characterised in that**
the moving data average (10), the moving clock average (18) and/or the moving EOT average (20) is/are formed at sampling rates that are less than the or a bit time, in particular less than one tenth or one hundredth, of the clock signal (3) of the Manchester-encoded signal (1),
and/or
**in that** the moving data average (10), the moving clock average (18) and/or the moving EOT average (29) is/are formed simultaneously with additional symbols (x) of the Manchester-encoded signal (1) being made available.

13. Decoding device (4)
comprising a signal input (5) for a Manchester-encoded signal (1)
and a clock signal output (16) for a clock signal (28) decoded from the Manchester-encoded signal (1),
and comprising a signal output (8) for a Manchester-decoded signal (6) and an end-of-transmission (EOT) signal output (26) for an EOT signal (34) derived from the Manchester-encoded signal (1),
wherein
a data signal flow path (7) is configured from the signal input (5) to a moving-type data averaging unit (9),
from there to a data comparator (11)
and from there to the data signal output (8),
and wherein an EOT signal flow path (25) is configured from the signal input (5) to an EOT comparator (30)
and from there to the EOT signal output (26),
**characterised in that**
the EOT signal flow path (25) is configured from the signal input (5) to a moving-type EOT averaging unit (28) and from there to the EOT comparator (30),
**in that** an EOT average time of the EOT averaging unit (28) is longer than a data average time of the data averaging unit (9),
**in that** the EOT comparator (30) is designed to output the EOT signal (34) depending on whether a result exceeds or falls below at least one EOT threshold (31, 32),
**in that** the data comparator (11) is designed to output an output signal (14) depending on whether a result exceeds an upper data threshold (13) and falls below a lower data threshold (12),
**in that** a control connection (42) is formed between the EOT comparator (30) and the data comparator (11), and the decoding device (4) is designed such that the upper data threshold (13) and the lower data threshold (12) in the data comparator (11) are or can be reset to standard values if an end of transmission is or has been detected in the EOT comparator (30),
and/or
**in that** a control connection is formed between the EOT comparator (30) and the moving-type data averaging unit (9) and/or a moving-type clock averaging unit (17), and the control connection is designed such that the data averaging unit (9) and/or the clock averaging unit (17) is/are reset if an end of transmission is detected in the EOT comparator (30).

14. Decoding device (4) according to the preceding claim,
**characterised in that**
a clock signal flow path (15) is configured from the signal input (5) to a moving-type clock averaging unit (17),
from there to a clock comparator (19)
and from there to the clock signal output (16),
in particular wherein
the EOT average time is longer than a clock average time of the clock averaging unit (17).

15. Decoding device (4) according to claim 14,
**characterised in that**
a linking device (24) is designed to logically link an output signal (14) of the data comparator (11) to an output signal (22) of the clock comparator (19).

16. Decoding device (4) to any of claims 13 to 15,
**characterised in that**
using the moving-type data averaging unit (9), a moving average of a signal (36) derived from the Manchester-encoded signal (1) can be formed over a data average time.

17. Decoding device (4) to any of claims 14 to 16,
**characterised in that**
using the moving-type clock averaging unit (17), a moving average of a signal (36) derived from the Manchester-encoded signal (1) can be formed over a clock average time.

18. Decoding device (4) to any of claims 13 to 17,
**characterised in that**
using the moving-type EOT averaging unit (28), a moving average of a signal (36) derived from the Manchester-encoded signal (1) can be formed over an EOT average time.

19. Decoding device (4) to any of claims 14 to 18,
**characterised in that**
the clock signal flow path (15) is guided from a signal output (39) of the linking device (24) to the clock signal output (16).

20. Decoding device (4) to any of claims 14 to 19,
**characterised in that**
the clock comparator (19) is designed to output an output signal (22) depending on whether a result exceeds or falls below at least one clock threshold (20, 21), in particular to output an output signal (22) depending on whether a result exceeds an upper clock threshold (21) of the at least one clock threshold (20, 21)
and/or
falls below a lower clock threshold (20) of the at least one clock threshold (20, 21).

21. Decoding device (4) to any of claims 13 to 20,
**characterised in that**
the EOT comparator (30) is designed to output an output signal (33) depending on whether a result exceeds an upper EOT threshold (32) of the at least one EOT threshold (31, 32) and/or
falls below a lower EOT threshold (31) of the at least one EOT threshold (31, 32).

22. Decoding device (4) to any of claims 13 to 21,
**characterised in that**
said device is designed to simultaneously and/or concurrently form the moving data average (10), the moving clock average (18) and/or the moving EOT average (29),
in particular wherein
the moving data average (10), the moving clock average (18) and/or the moving EOT average (29) can be formed at sampling rates
that are less than the or a bit time,
in particular less than one tenth or one hundredth,
of the or a clock signal (3) of the Manchester-encoded signal (1),
and/or
**in that** said device is designed to form the moving data average (10), the moving clock average (18) and/or the moving EOT average (29) simultaneously with additional symbols of the Manchester-encoded signal (1) being made available.

## Revendications

1. Procédé de décodage pour un signal codé Manchester,
selon lequel
une valeur moyenne mobile de données (10) ayant un temps de valeur moyenne de données est formée pour le signal codé Manchester (1) et
un signal de données décodé (6) est formé à partir de la valeur moyenne mobile de données (10) avec un comparateur de données (11) et mis à disposition,
**caractérisé en ce**
**qu'**une valeur moyenne mobile EOT (fin de transmission) (29) ayant un temps de valeur moyenne EOT est formée pour le signal codé Manchester (1),
**que** le temps de valeur moyenne EOT est plus long que le temps de valeur moyenne de données,
**qu'**un signal EOT (34) est formé à partir de la valeur moyenne mobile EOT (29) avec un comparateur EOT (30) et mis à disposition,
**que** le comparateur EOT (30) délivre le signal EOT (34) en fonction d'un dépassement vers le haut ou vers le bas d'au moins une valeur seuil EOT (31, 32),
**que** le comparateur de données (11) compare la valeur moyenne mobile de données (10) avec au moins une valeur seuil de données (12), 13) et délivre le signal de données décodé (6) en fonction d'un dépassement vers le haut ou vers le bas de ladite au moins une valeur seuil de données (12, 13),
**que** ladite au moins une valeur seuil de données (12, 13) comprend une valeur seuil de données inférieure (12) et une valeur seuil de données supérieure (13) et le comparateur de données (11) délivre le signal de données décodé (6) en fonction d'un dépassement vers le haut de la valeur seuil de données supérieure (13) et d'un dépassement vers le bas de la valeur seuil de données inférieure (12) et
**que** ladite au moins une valeur seuil de données (12, 13) est réinitialisée aux valeurs par défaut dans le comparateur de données (11) via une liaison de commande (42) formée entre le comparateur EOT (30) et le comparateur de données (11) lorsqu'une fin de transmission est détectée dans le comparateur EOT (30),
et/ou
**que** le formateur de valeur moyenne de données (9) et/ou un formateur de valeur moyenne d'horloge (17) est ou sont réinitialisé(s) via une liaison de commande formée entre le comparateur EOT (30) et le formateur de valeur moyenne mobile de données (9) et/ou le formateur de valeur moyenne mobile d'horloge (17) lorsqu'une fin de transmission est détectée dans le comparateur EOT (30).

2. Procédé de décodage selon la revendication précédente,
**caractérisé en ce qu'**une valeur moyenne mobile d'horloge (18) ayant un temps de valeur moyenne d'horloge est formée pour le signal codé Manchester (1)
et qu'un signal d'horloge (23) est formé au moins à partir de la valeur moyenne mobile d'horloge (18) avec un comparateur d'horloge (19) et mis à disposition,
en particulier le temps de valeur moyenne EOT étant plus long que le temps de valeur moyenne d'horloge.

3. Procédé de décodage selon la revendication précédente,
**caractérisé en ce que**,
pour former le signal d'horloge (23), un signal de sortie (22) du comparateur d'horloge (19) est combiné logiquement avec le signal de données décodé (6).

4. Procédé de décodage selon l'une des revendications précédentes,
**caractérisé en ce que**,
pour former le signal d'horloge (23), le signal de sortie (22) du comparateur d'horloge (19) est combiné logiquement avec signal de données (6), en particulier par combinaison XOR.

5. Procédé de décodage selon l'une des revendications 2 à 4,
**caractérisé en ce**
**que** le temps de valeur moyenne d'horloge est plus court que le temps de valeur moyenne de données et/ou
**que**, pour former la valeur moyenne mobile de données (10), d'horloge (18) et/ou EOT (29), un signal (36) dérivé du signal codé Manchester (1) est intégré sur le temps de valeur moyenne de données, d'horloge et/ou EOT.

6. Procédé de décodage selon l'une des revendications 2 à 5,
**caractérisé en ce**
**que**, pour former la valeur moyenne mobile de données (10), d'horloge (18) et/ou EOT (29), un signal différentiel de différences entre chaque symbole x du signal codé Manchester et un symbole du signal codé Manchester (1) décalé dans le temps d'une durée prédéterminée L par rapport à ce symbole x est progressivement formé en tant que signal (36) dérivé du signal codé Manchester (1).

7. Procédé de décodage selon l'une des revendications précédentes,
**caractérisé en ce**
**qu'**une valeur moyenne arithmétique de la valeur seuil de données inférieure (12) et de la valeur seuil de données supérieure (13) se situe entre zéro et un, en particulier à 1/2,
et/ou
**qu'**une durée qui est supérieure à un demi-temps de bit et/ou inférieure à 1,5 fois le temps de bit, en particulier égale au temps de bit, d'un signal horloge (3) du signal codé Manchester (1) est définie comme temps de valeur moyenne de données.

8. Procédé de décodage selon l'une des revendications précédentes,
**caractérisé en ce**
**qu'**une durée qui est inférieure à un temps de bit, en particulier égale au demi-temps de bit, d'un signal d'horloge (3) du signal codé Manchester (1) est définie comme temps de valeur moyenne d'horloge
et/ou
**qu'**une durée qui est supérieure à un temps de bit, en particulier égale à 1,5 fois le temps de bit, d'un signal d'horloge (3) du signal codé Manchester (1) est définie comme le temps de valeur moyenne EOT.

9. Procédé de décodage selon l'une des revendications 2 à 8,
**caractérisé en ce**
**que** le comparateur d'horloge (19) compare la valeur moyenne mobile d'horloge (18) avec au moins une valeur seuil d'horloge (20, 21) et délivre un signal de sortie (22) en fonction d'un dépassement vers le haut ou vers le bas de ladite au moins une valeur seuil d'horloge (20, 21).

10. Procédé de décodage selon l'une des revendications 2 à 9,
**caractérisé en ce**
**que** ladite au moins une valeur seuil d'horloge (20, 21) comprend une valeur seuil d'horloge inférieure (20) et une valeur seuil d'horloge supérieure (21) et que le comparateur d'horloge (19) délivre un signal de sortie (22) en fonction d'un dépassement vers le haut de la valeur seuil d'horloge supérieure (21) et/ou d'un dépassement vers le bas de la valeur seuil d'horloge inférieure (20).

11. Procédé de décodage selon la revendication précédente,
**caractérisé en ce**
**qu'**une valeur moyenne arithmétique de la valeur seuil d'horloge inférieure (20) et de la valeur seuil d'horloge supérieure (21) se situe entre zéro et un, en particulier au-dessous de la valeur moyenne arithmétique (20) de la valeur seuil de données inférieure (12) et de la valeur seuil de données supérieure (8) et/ou à 1/4, et/ou que la valeur moyenne mobile de données (10), d'horloge (18) et/ou EOT (29) est/sont formée(s) simultanément et/ou parallèlement entre elles dans le temps.

12. Procédé de décodage selon l'une des revendications 2 à 11,
**caractérisé en ce**
**que** la valeur moyenne mobile de données (10), d'horloge (18) et/ou EOT (20) est/sont formée(s) à une fréquence d'échantillonnage qui est chaque fois inférieure au temps de bit ou à un temps de bit, en particulier inférieure à un dixième ou un centième du signal d'horloge (3) du signal codé Manchester (1),
et/ou
**que** la valeur moyenne mobile de données (10), d'horloge (18) et/ou EOT (29) est/sont formée(s) simultanément à une mise à disposition d'autres symboles (x) du signal codé Manchester (1).

13. Dispositif de décodage (4),
comprenant une entrée de signal (5) pour un signal codé Manchester (1)
et une sortie de signal d'horloge (16) pour un signal d'horloge décodé (28) à partir du signal codé Manchester (1),
et comprenant une sortie de signal (8) pour un signal décodé Manchester (6) et une sortie de signal EOT (end of transmission, fin de transmission) (26) pour un signal EOT (34) dérivé du signal codé Manchester (1),
dans lequel
un trajet de flux de signal de données (7) est formé de l'entrée de signal (5) vers un formateur de valeur moyenne mobile de données (9),
de celui-ci vers un comparateur de données (11)
et de celui-ci vers la sortie de signal de données (8),
et dans lequel un trajet de flux de signal EOT (25) est formé de l'entrée de signal (5) vers un comparateur EOT (30)
et de celui-ci vers la sortie de signal EOT (26),
**caractérisé en ce**
**que** le trajet de flux de signal EOT (25) est formé de l'entrée de signal (5) vers un formateur de valeur moyenne mobile EOT (28) et de celui-ci vers le comparateur EOT (30),
**qu'**un temps de valeur moyenne EOT du formateur de valeur moyenne EOT (28) est plus long qu'un temps de valeur moyenne de données du formateur de valeur moyenne de données (9),
**que** le comparateur EOT (30) est conçu pour délivrer le signal EOT (34) en fonction d'un dépassement vers le haut ou vers le bas d'au moins une valeur seuil EOT (31, 32),
**que** le comparateur de données (11) est conçu pour délivrer un signal de sortie (14) en fonction d'un dépassement vers le haut d'une valeur seuil de données supérieure (13) et d'un dépassement vers le bas d'une valeur seuil de données inférieure (12),
**qu'**une liaison de commande (42) est formée entre le comparateur EOT (30) et le comparateur de données (11), et le dispositif de décodage (4) est conçu de telle sorte que la valeur seuil de données supérieure (13) et la valeur seuil de données inférieure (12) peuvent être réinitialisées ou sont réinitialisées aux valeurs par défaut dans le comparateur de données (11) lorsqu'une fin de transmission est détectée dans le comparateur EOT (30),
et/ou
**qu'**une liaison de commande est formée entre le comparateur EOT (30) et le formateur de valeur moyenne mobile de données (9) et/ou un formateur de valeur moyenne mobile d'horloge (17), et la liaison de commande est conçue de telle sorte que le formateur de valeur moyenne de données (9) et/ou le formateur de valeur moyenne d'horloge (17) est ou sont réinitialisé(s) lorsqu'une fin de transmission est détectée dans le comparateur EOT (30).

14. Dispositif de décodage (4) selon la revendication précédente,
**caractérisé en ce**
**qu'**un trajet de flux de signal d'horloge (15) est formé de l'entrée de signal (5) vers un formateur de valeur moyenne mobile d'horloge (17),
de celui-ci vers un comparateur d'horloge (19)
et de celui-ci vers la sortie de signal d'horloge (16),
en particulier le temps de valeur moyenne EOT étant plus long qu'un temps de valeur moyenne d'horloge du formateur de valeur moyenne d'horloge (17).

15. Dispositif de décodage (4) selon la revendication 14,
**caractérisé en ce**
**qu'**un dispositif de combinaison (24) est conçu pour combiner logiquement un signal de sortie (14) du comparateur de données (11) avec un signal de sortie (22) du comparateur d'horloge (19).

16. Dispositif de décodage (4) selon l'une des revendications 13 à 15,
**caractérisé en ce**
**que** le formateur de valeur moyenne mobile de données (9) permet de former une valeur moyenne mobile d'un signal (36) dérivé du signal codé Manchester (1) sur un temps de valeur moyenne de données.

17. Dispositif de décodage (4) selon l'une des revendications 14 à 16,
**caractérisé en ce**
**que** le formateur de valeur moyenne mobile d'horloge (17) permet de former une valeur moyenne mobile d'un signal (36) dérivé du signal codé Manchester (1) sur un temps de valeur moyenne d'horloge.

18. Dispositif de décodage (4) selon l'une des revendications 13 à 17,
**caractérisé en ce**
**que** le formateur de valeur moyenne mobile EOT (28) permet de former une valeur moyenne mobile d'un signal (36) dérivé du signal codé Manchester (1) sur un temps de valeur moyenne EOT.

19. Dispositif de décodage (4) selon l'une des revendications 14 à 18,
**caractérisé en ce**
**que** le trajet de flux de signal d'horloge (15) va d'une sortie de signal (39) du dispositif de combinaison (24) vers la sortie de signal d'horloge (16).

20. Dispositif de décodage (4) selon l'une des revendications 14 à 19,
**caractérisé en ce**
**que** le comparateur d'horloge (19) est conçu pour délivrer un signal de sortie (22) en fonction d'un dépassement vers le haut ou vers le bas d'au moins une valeur seuil d'horloge (20, 21), en particulier pour délivrer un signal de sortie (22) en fonction d'un dépassement vers le haut d'une valeur seuil d'horloge supérieure (21) de ladite au moins une valeur seuil d'horloge (20, 21) et/ou d'un dépassement vers le bas d'une valeur seuil d'horloge inférieure (20) de ladite au moins une valeur seuil d'horloge (20, 21).

21. Dispositif de décodage (4) selon l'une des revendications 13 à 20,
**caractérisé en ce**
**que** le comparateur EOT (30) est conçu pour délivrer un signal de sortie (33) en fonction d'un dépassement vers le haut d'une valeur seuil EOT supérieure (32) de ladite au moins une valeur seuil EOT (31, 32) et/ou d'un dépassement vers le bas d'une valeur seuil EOT inférieure (31) de ladite au moins une valeur seuil EOT (31, 32).

22. Dispositif de décodage (4) selon l'une des revendications 13 à 21,
**caractérisé en ce qu'**il est conçu pour former simultanément et/ou parallèlement dans le temps les valeurs moyennes mobiles de données (10), d'horloge (18) et/ou EOT (29),
en particulier dans lequel
les valeurs moyennes mobiles de données (10), d'horloge (18) et/ou EOT (29) peuvent être formées à une fréquence d'échantillonnage qui est chaque fois inférieure au temps de bit ou à un temps de bit, en particulier inférieure à un dixième ou un centième du ou d'un signal d'horloge (3) du signal codé Manchester (1)
et/ou
qu'il est conçu pour former simultanément et/ou parallèlement dans le temps les valeurs moyennes mobiles de données (10), d'horloge (18) et/ou EOT (29) avec la mise à disposition d'autres symboles du signal codé Manchester (1).
